# EUROPEAN PATENT APPLICATION

(11) **EP 4 723 168 A1**
(43) Date of publication of application: **08.04.2026**
(21) Application number: 25182367.0
(22) Date of filing: 12.06.2025
(51) Int. Cl.: H01L 23/31, H10D 30/01, H10D 62/17, H10D 64/00, H10D 30/47, H10D 62/85, H10D 64/23

(54) **SEMICONDUCTOR DEVICE**

(30) Priority: 02.10.2024 KR 20240133994; 23.10.2024 KR 20240146004
(71) Applicant: Samsung Electronics Co., Ltd., Suwon-si, Gyeonggi-do 16677 (KR)
(72) Inventor: PARK, Junhyuk, Suwon-si (KR); KIM, Boram, Suwon-si (KR); KIM, Jongseob, Suwon-si (KR); KIM, Joonyong, Suwon-si (KR); YANG, Seong Seok, Suwon-si (KR)
(74) Representative: Marks & Clerk LLP

(57) **Abstract**

A semiconductor device may include a channel layer, a barrier layer located on the channel layer, and including a material having a different energy band gap from the channel layer, a gate electrode located on the barrier layer, a gate semiconductor layer located between the barrier layer and the gate electrode, a protective layer located on the barrier layer and covering the gate electrode, and a source electrode and a drain electrode located on opposite sides of the gate electrode, and electrically connected to the channel layer, where the protective layer may include a first protective layer located on the barrier layer, and comprising a first insulating material containing deuterium, and a second protective layer located on the first protective layer, and comprising a second insulating material that does not contain deuterium.

## Description

### BACKGROUND

In modern society, semiconductor devices are closely related to daily life. Particularly, the importance of power semiconductor devices used in various fields such as transportation fields such as electric vehicles, railroads, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, so they may handle large amounts of current and withstand high voltage. For example, power semiconductor devices may handle voltages from hundreds of volts to thousands of volts and currents from tens of amperes to thousands of amperes. Power semiconductor devices may improve the efficiency of electrical energy by minimizing power loss. In addition, power semiconductor devices may be stably driven even in environments such as high temperatures.

These power semiconductor devices may be classified according to materials, and examples thereof include SiC power semiconductor devices and GaN power semiconductor devices. By manufacturing power semiconductor devices using SiC or GaN instead of existing silicon (Si), the disadvantages of silicon having unstable characteristics at high temperatures may be compensated. SiC power semiconductor devices may be resistant to high temperatures, have low power loss, and be suitable for electric vehicles and renewable energy systems. GaN power semiconductor devices may require high costs, but may be efficient in terms of speed and be suitable for high-speed charging of mobile devices.

### SUMMARY

The present disclosure provides semiconductor devices with improved reliability.

A semiconductor device may include a channel layer, a barrier layer located on the channel layer, and including a material having a different energy band gap from the channel layer, a gate electrode located on the barrier layer, a gate semiconductor layer located between the barrier layer and the gate electrode, a protective layer located on the barrier layer and covering the gate electrode, and a source electrode and a drain electrode located on opposite sides of the gate electrode, and electrically connected to the channel layer, where the protective layer may include a first protective layer located on the barrier layer, and comprising a first insulating material containing deuterium, and a second protective layer located on the first protective layer, and comprising a second insulating material that does not contain deuterium.

A semiconductor device may include a channel layer including GaN, a barrier layer located on the channel layer, including AlGaN, and including an implant region containing deuterium, a gate electrode located on the barrier layer, and including a metal material, a gate semiconductor layer located between the barrier layer and the gate electrode, and including GaN doped with p-type impurities, a protective layer located on the barrier layer and covering the gate electrode, and a source electrode and a drain electrode located on opposite sides of the gate electrode, and electrically connected to the channel layer, where the protective layer may include a first protective layer located on the implant region, and containing deuterium, and a second protective layer located on the first protective layer.

A semiconductor device may include a channel layer, a barrier layer located on the channel layer, and including a material having a different energy band gap from the channel layer, and including an implant region containing deuterium, a gate electrode located on the barrier layer, a gate semiconductor layer located between the barrier layer and the gate electrode, a protective layer located on the implant region and covering the gate electrode, and a source electrode and a drain electrode located on opposite sides of the gate electrode, and electrically connected to the channel layer, where the implant region is located between the gate electrode and the source electrode and between the gate electrode and the drain electrode, and where the protective layer may include a first protective layer located on the barrier layer, and including silicon oxide containing deuterium, and a second protective layer located on the first protective layer, and including silicon nitride or silicon nitride oxide, which does not contain deuterium.

Based on the foregoing and other characteristics as described herein, the reliability of the semiconductor device may be improved.

At least some of the above and other features of the invention are set out in the claims.

### BRIEF DESCRIPTION OF THE DRAWINGS

FIG. 1 and FIG. 2 are cross-sectional views showing an example of a semiconductor device.
FIG. 3, 4A, 4B, 4C, 4D, and 5 are graphs showing deuterium content in a barrier layer and a protective layer of a semiconductor device.
FIGS. 6 to 12 are cross-sectional views showing examples of semiconductor devices.
FIGS. 14 to 21 are cross-sectional views showing an example of a process sequence of manufacturing a semiconductor device.
FIGS. 22 to 25 are cross-sectional views showing an example of a process sequence of manufacturing a semiconductor device.

### DETAILED DESCRIPTION

The present description is provided with reference to the accompanying drawings. As those skilled in the art would realize, the scope of this disclosure is not limited to the illustrated examples, and various implementations are within the scope of this disclosure.

For clarity of description, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area, or substrate is referred to as being "on" or "above" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

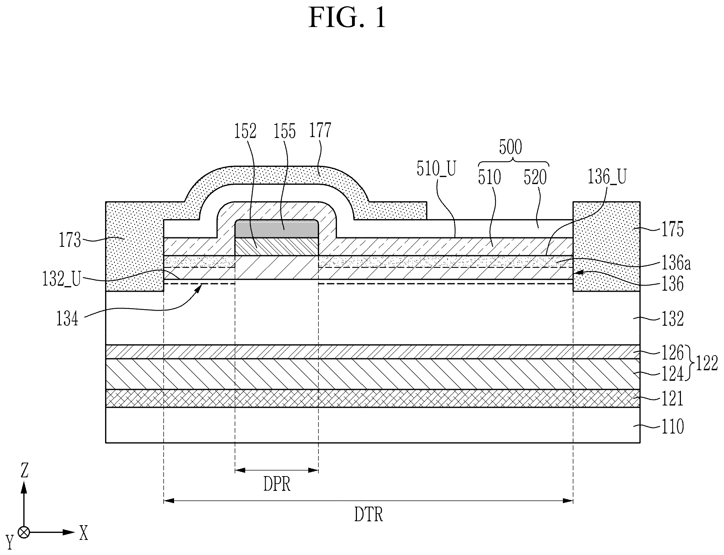

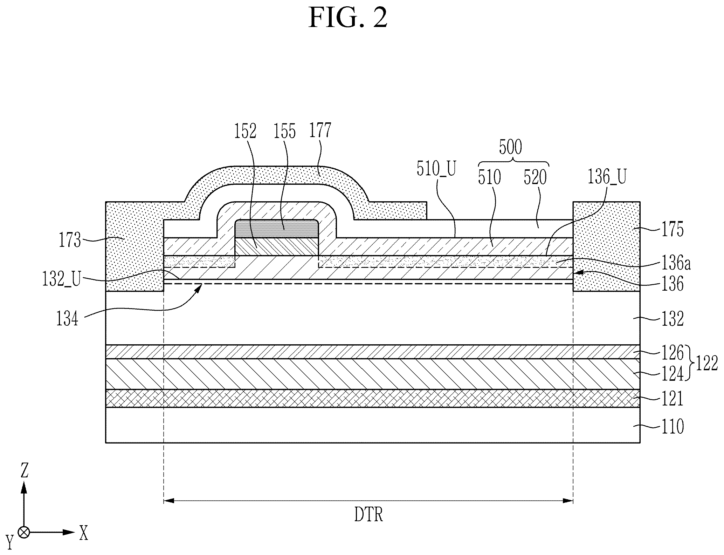

An example of a semiconductor device will now be described with reference to FIG. 1 and FIG. 2. FIG. 1 shows a case in which a semiconductor device is in an off-state, and FIG. 2 shows a case in which the semiconductor device is in an on-state.

Referring to FIG. 1 and FIG. 2, a semiconductor device may include a channel layer 132, a barrier layer 136 located on the channel layer 132, a gate electrode 155 located on the barrier layer 136, a gate semiconductor layer 152 located between the barrier layer 136 and the gate electrode 155, a protective layer 500 located on the barrier layer 136 and covering the gate electrode 155, and a source electrode 173 and a drain electrode 175 located on opposite sides of the gate electrode 155 and electrically connected to the channel layer 132.

The channel layer 132 is a layer that forms a channel between the source electrode 173 and the drain electrode 175, and a 2-dimensional electron gas (2DEG) 134 may be located inside the channel layer 132. The two-dimensional electron gas 134 is a charge transport model used in solid state physics, which refers to a group of electrons that may move freely in two-dimensions (for example, in the x-y plane direction), but are firmly confined within the two-dimensions and cannot move in another dimension (for example, in the z direction). In other words, the 2-dimensional electron gas 134 may exist in a 2-dimensional sheet-like form within a 3-dimensional space. The 2-dimensional electron gas 134 mainly appears in a semiconductor heterojunction structure, and in the semiconductor device shown in FIGS. 1-2, may occur at an interface between the channel layer 132 and the barrier layer 136. For example, the two-dimensional electron gas 134 may be generated in a portion of the channel layer 132 adjacent to the barrier layer 136.

The channel layer 132 may include one or more materials selected from Group III-V materials, for example, nitrides including Al, Ga, In, B, or a combination thereof. The channel layer 132 may be formed as a single layer or a multilayer. The channel layer 132 may be AlₓIn_{y}Ga_{1-x-y}N (0≤x≤1, 0≤y≤1, x+y≤1). For example, the channel layer 132 may include AIN, GaN, InN, InGaN, AlGaN, AlInN, AllnGaN, or a combination thereof. The channel layer 132 may be a layer doped with impurities or a layer undoped with impurities. A thickness of the channel layer 132 may be about several hundred nm or less.

The channel layer 132 may be located on a substrate 110, and a seed layer 121 and a buffer layer 122 may be located between the substrate 110 and the channel layer 132. The substrate 110, the seed layer 121, and the buffer layer 122 are layers used to form the channel layer 132, and may be omitted in some cases. For example, when a substrate made of GaN is used as the channel layer 132, at least one of the substrate 110, the seed layer 121, and the buffer layer 122 may be omitted. Considering that the price of the substrate made of GaN is relatively high, the channel layer 132 including GaN may be grown using the substrate 110 made of Si. In this case, it may not be easy to grow the channel layer 132 directly on the substrate 110 because a lattice structure of Si and a lattice structure of GaN are different. Accordingly, the seed layer 121 and the buffer layer 122 may be first grown on the substrate 110, and then the channel layer 132 may be grown on the buffer layer 122. In addition, at least one of the substrate 110, the seed layer 121, and the buffer layer 122 may be used in the manufacturing process and then removed from the final structure of the semiconductor device.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited thereto, and all generally used substrates may be applied. In some cases, the substrate 110 may include an insulating material. For example, several layers, including the channel layer 132, may be first formed on a semiconductor substrate, and then the semiconductor substrate may be removed and replaced with an insulating substrate.

The seed layer 121 may be located directly on the substrate 110. However, the present disclosure is not limited thereto, and another predetermined layer may be further located between the substrate 110 and the seed layer 121. The seed layer 121 is a layer that serves as a seed for growing the buffer layer 122, and may be formed of a crystal lattice structure that becomes the seed of the buffer layer 122. The buffer layer 122 may be located directly on the seed layer 121. However, the present disclosure is not limited thereto, and another predetermined layer may be further located between the seed layer 121 and the buffer layer 122. The seed layer 121 may include one or more materials selected from Group III-V materials, for example, nitrides including Al, Ga, In, B, or a combination thereof. The seed layer 121 may be AlₓIn_{y}Ga_{1-x-y}N (0≤x≤1, 0≤y≤1, x+y≤1). For example, the seed layer 121 may include AIN, GaN, InN, InGaN, AlGaN, AlInN, AlInGaN, or a combination thereof.

The buffer layer 122 may be located on the seed layer 121. The buffer layer 122 may be located between the seed layer 121 and the channel layer 132. The buffer layer 122 may be a layer to alleviate the difference in lattice constant and thermal expansion coefficient between the seed layer 121 and the channel layer 132, and/or to prevent a parasitic current (leakage current) from flowing through the channel layer 132. The buffer layer 122 may include one or more materials selected from Group III-V materials, for example, nitrides including Al, Ga, In, B, or a combination thereof. The buffer layer 122 may be AlₓIn_{y}Ga_{1-x-y}N (0≤x≤1, 0≤y≤1, x+y≤1). For example, the buffer layer 122 may include AIN, GaN, InN, InGaN, AlGaN, AlInN, AllnGaN, or a combination thereof.

The buffer layer 122 of the semiconductor device may include a superlattice layer 124 located on the seed layer 121, and a high resistance layer 126 located on the superlattice layer 124. The superlattice layer 124 and the high resistance layer 126 may be sequentially located on the substrate 110.

The superlattice layer 124 may be located on the seed layer 121. The superlattice layer 124 may be located directly on the seed layer 121. However, the present disclosure is not limited thereto, and another predetermined layer may be further located between the seed layer 121 and the superlattice layer 124. The superlattice layer 124 is a layer for alleviating the difference in lattice constant and thermal expansion coefficient between the substrate 110 and the channel layer 132, thereby alleviating tensile stress and compressive stress generated between the substrate 110 and the channel layer 132, and alleviating stress between all layers formed by growth in the final structure of the semiconductor device. The superlattice layer 124 may include one or more materials selected from group III-V materials, for example, nitrides containing Al, Ga, In, B, or a combination thereof. The superlattice layer 124 may be AlₓIn_{y}Ga_{1-x-y}N (0≤x≤1, 0≤y≤1, x+y≤1). For example, the superlattice layer 124 may include AIN, GaN, InN, InGaN, AlGaN, AlInN, AlInGaN, or a combination thereof.

The superlattice layer 124 may be composed of multiple layers in which layers containing different materials are alternately stacked. For example, the superlattice layer 124 may have a structure in which a layer made of AlGaN and a layer made of AIN are repeatedly stacked. For example, AlGaN/AlN/AlGaN/AlN/AlGaN/AlN may be sequentially stacked to form the superlattice layer. The number of AlGaN layers and GaN layers forming the superlattice layer 124 may be variously changed, and the material configuring the superlattice layer 124 may vary in different implementations. For example, the superlattice layer 124 may have a structure in which a layer made of AlGaN and a layer made of GaN are repeatedly stacked. For example, AlGaN/GaN/AlGaN/GaN/AlGaN/GaN may be sequentially stacked to form the superlattice layer. In some implementation (e.g., when the superlattice layer 124 includes GaN, InN, AlGaN, AlInN, InGaN, AIN, AIN, AllnGaN, or a combination thereof), the superlattice layer 124 may have n-type semiconductor characteristics in which the concentration of electrons is greater than the concentration of holes, but the materials and type of conductivity of the superlattice layer 124 are not limited thereto.

The high-resistance layer 126 may be located on the superlattice layer 124. The high resistance layer 126 may be located directly on the superlattice layer 124. However, the present disclosure is not limited thereto, and another predetermined layer may be further located between the superlattice layer 124 and the high resistance layer 126. The high resistance layer 126 may be located between the superlattice layer 124 and the channel layer 132. The high resistance layer 126 is a layer for preventing a leakage current from flowing through the channel layer 132, thereby preventing the semiconductor device from deteriorating. The high resistance layer 126 may be made of a material with low conductivity to electrically insulate the substrate 110 and the channel layer 132. The high-resistance layer may include one or more materials selected from Group III-V materials, for example, nitrides including Al, Ga, In, B, or a combination thereof. The high-resistance layer 126 may be AlₓIn_{y}Ga_{1-x-y}N (0≤x≤1, 0≤y≤1, x+y≤1). For example, the high-resistance layer 126 may include AIN, GaN, InN, InGaN, AlGaN, AlInN, AllnGaN, or a combination thereof. The high resistance layer 126 may be formed as a single layer or a multilayer.

The semiconductor device may further include the barrier layer 136 located on the channel layer 132. The barrier layer 136 may be located on the channel layer 132. The barrier layer 136 may be located directly on the channel layer 132. However, the present disclosure is not limited thereto, and another predetermined layer may be further located between the channel layer 132 and the barrier layer 136. The region of the channel layer 132 that overlaps the barrier layer 136 between the source electrode 173 and the drain electrode 175 may be a drift region DTR. The drift region DTR may be located between the source electrode 173 and the drain electrode 175. The drift region DTR may mean a region in which a carrier moves when a potential difference occurs between the source electrode 173 and the drain electrode 175.

The semiconductor device may be turned on/off according to whether a voltage is applied to the gate electrode 155 and/or the magnitude of the voltage applied to the gate electrode 155, and accordingly, carrier movement in the drift region DTR may be performed or blocked.

The barrier layer 136 may include one or more materials selected from Group III-V materials, for example, nitrides including Al, Ga, In, B, or a combination thereof. The barrier layer 136 may be AlₓIn_{y}Ga_{1-x-y}N (0≤x≤1, 0≤y≤1, x+y≤1). The barrier layer 136 may include GaN, InN, AlGaN, AlInN, InGaN, AIN, AllnGaN or a combination thereof, or the like. An energy band gap of the barrier layer 136 may be adjusted by a composition ratio of Al and/or In. The barrier layer 136 may be doped with a predetermined impurity. In this case, the impurity doped in the barrier layer 136 may be a p-type dopant that may provide a hole. For example, the impurity doped into the barrier layer 136 may be magnesium (Mg). By increasing or decreasing the impurity doping concentration of the barrier layer 136, the threshold voltage, temperature, resistance, and the like of the semiconductor device may be adjusted.

The barrier layer 136 may include a semiconductor material with characteristics different from those of the channel layer 132. The barrier layer 136 may be different from the channel layer 132 in at least one of polarization characteristic, energy band gap, and lattice constant. For example, the barrier layer 136 may include a material having an energy band gap different from that of the channel layer 132. In this case, the barrier layer 136 may have a higher energy band gap than the channel layer 132, and may have a higher electrical polarization rate than the channel layer 132. The 2-dimensional electron gas 134 may be induced in the channel layer 132 having a relatively low electrical polarization rate by the barrier layer 136. In this regard, the barrier layer 136 may be referred to as a channel supply layer or a two-dimensional electron gas supply layer. The two-dimensional electron gas 134 may be formed within a portion of the channel layer 132 located below the interface between the channel layer 132 and the barrier layer 136. The two-dimensional electron gas 134 may have very high electron mobility. In some implementations, at least a portion of the barrier layer 136 includes deuterium (D). For example, the barrier layer 136 may be formed of AlGaN containing deuterium (D).

The barrier layer 136 of the semiconductor device may include an implant region 136a containing deuterium (D). The implant region 136a may mean a region containing deuterium (D) within the barrier layer 136.

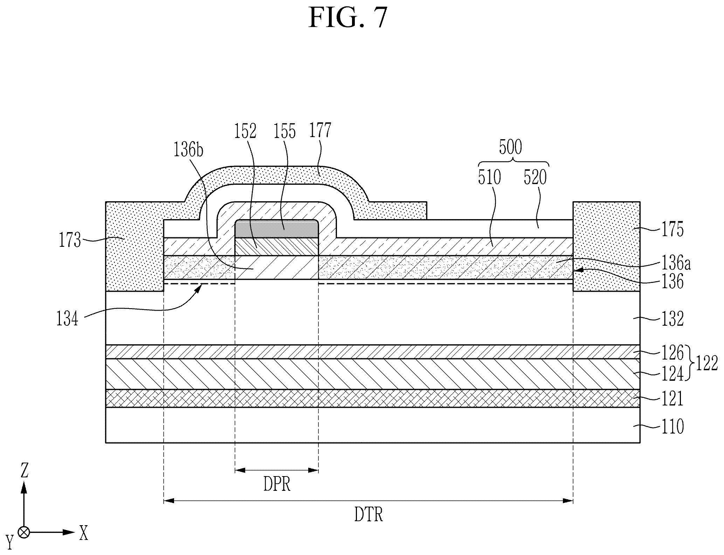

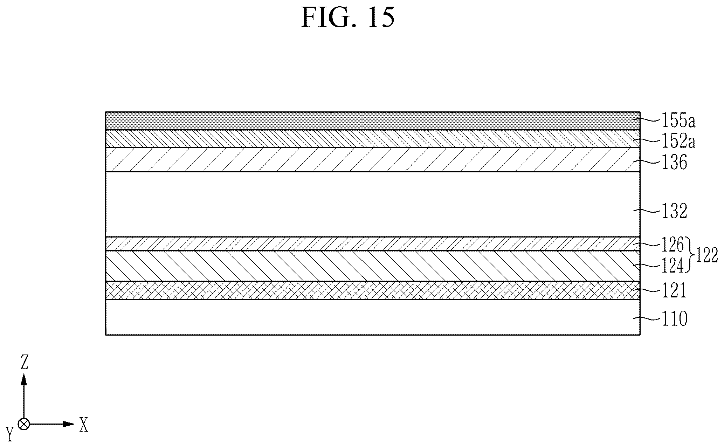

The implant region 136a may be located in an upper portion of the barrier layer 136. The implant region 136a may constitute at least a portion of an upper surface 136_U of the barrier layer 136. An upper surface of the implant region 136a may be in contact with a first protective layer 510 to be described later. The implant region 136a may overlap with the channel layer 132 in a third direction (Z direction). The implant region 136a may be spaced apart from an upper surface 132_U of the channel layer 132 in the third direction (Z direction), but is not limited thereto. As another example, the implant region 136a may be in contact with the upper surface 132_U of the channel layer 132. This will be later described in detail with reference to FIG. 7. In addition, the implant region 136a may not overlap with (may be non-overlapping with) the gate electrode 155 and the gate semiconductor layer 152, to be described later, in or along the third direction (Z direction). This may be due to the process characteristics of forming the gate semiconductor layer 152 and the gate electrode 155 by patterning a gate semiconductor material layer 152a (see FIG. 15) and a gate electrode material layer 155a (see FIG. 15) located on the barrier layer 136.

The implant region 136a may be in contact with a side surface of the source electrode 173 and the drain electrode 175. For example, the implant region 136a may be in contact with a portion of the side surface of the source electrode 173 and a side surface of the drain electrode 175.

The implant region 136a may be between a portion of the barrier layer 136 that overlaps the gate electrode 155 along a vertical direction and the source electrode 173 and may be between the portion of the barrier layer 136 that overlaps the gate electrode 155 along a vertical direction and the drain electrode 175.

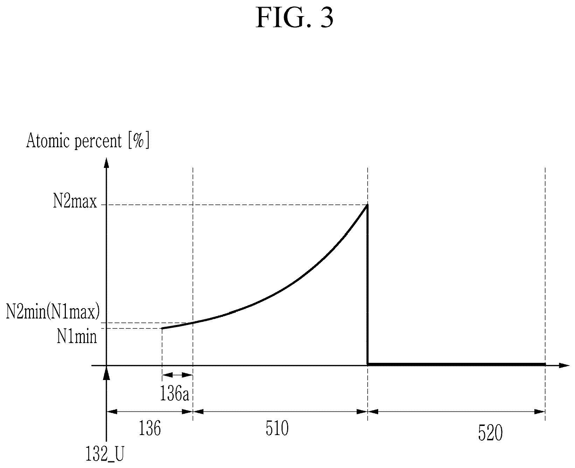

The implant region 136a may include deuterium (D). For example, the implant region 136a may be formed of AlGaN containing deuterium (D). The implant region 136a may have different content (at%) (or concentration) of deuterium (D), away from the upper surface 132_U of the channel layer 132. In addition, a content (at%) of deuterium (D) of the implant region 136a may be different from a content (at%) of deuterium (D) of the first protective layer 510 to be described later. This will be described later in reference to FIG. 3 to FIG. 5.

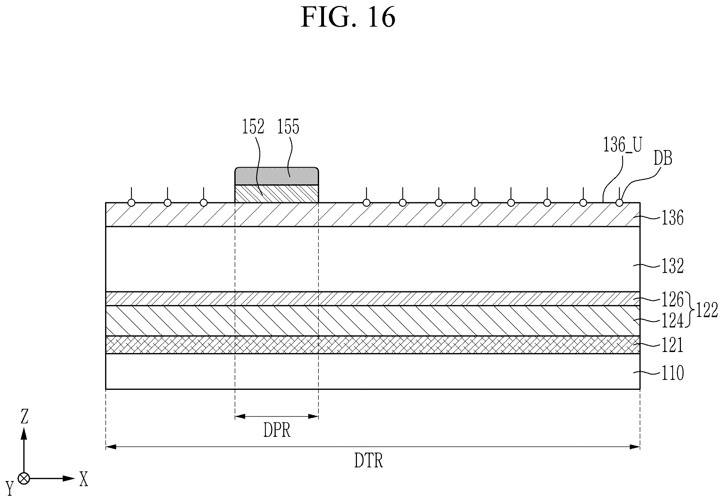

In some implementations, a defect may exist in the crystal structure of the elements constituting the barrier layer 136. For example, when the barrier layer 136 includes gallium (Ga) and nitrogen (N), a point defect including a vacancy, or the like, may exist within the crystal structure of gallium (Ga) and nitrogen(N). In addition, during the process of forming the gate semiconductor layer 152 and the gate electrode 155 by patterning the gate semiconductor material layer 152a (see FIG. 15) and the gate electrode material layer 155a (see FIG. 15) located on the barrier layer 136, a dangling bond DB (see FIG. 16) may occur on the upper surface 136_U of the barrier layer 136. The dangling bond DB may mean a state in which some bonds of some atoms within the crystal structure of the barrier layer 136 with surrounding atoms are broken due to coordinative unsaturation. By the vacancy and/or the dangling bond DB of the barrier layer 136, a portion of the 2-dimensional electron gas 134 or the like may be trapped, or external impurities may be bonded, thereby deteriorating the device characteristics.

As the high-pressure deuterium (HPD) annealing is performed on at least a partial region (e.g., the implant region 136a) of the barrier layer 136 of the semiconductor device, deuterium (D) may be implanted into the vacancy located in the barrier layer 136 and/or into the region generated by the dangling bond DB (see FIG. 16), and deuterium (D) may be bonded with surrounding elements. Therefore, a ratio or number of the vacancy and the dangling bond DB (see FIG. 16) that exist in the barrier layer 136 may decrease, and accordingly, the barrier layer 136 may be effectively passivated. The 2-dimensional electron gas 134 may be prevented from leaking to a portion other than the interface between the barrier layer 136 and the channel layer 132, and the reliability of the semiconductor device may be improved.

The barrier layer 136 may be formed in a single layer or multiple layers. When the barrier layer 136 is formed in multiple layers, the material of respective layers constituting the multiple layers may have different energy band gaps. The multiple layers constituting the barrier layer 136 may be disposed such that the energy band gap becomes larger the closer they are to the channel layer 132.

The gate electrode 155 may be located on the barrier layer 136. The gate electrode 155 may overlap with a portion or region of the barrier layer 136 in the third direction (Z direction). The gate electrode 155 may overlap with a portion of the drift region DTR of the channel layer 132 in the third direction (Z direction). The gate electrode 155 may be located between the source electrode 173 and the drain electrode 175. The gate electrode 155 may be spaced apart from the source electrode 173 and the drain electrode 175. For example, the gate electrode 155 may be located closer to the source electrode 173 than the drain electrode 175. That is, a spacing distance between the gate electrode 155 and the source electrode 173 may be smaller than a spacing distance between the gate electrode 155 and the drain electrode 175, but the spacings are not limited thereto. Here, the third direction (Z direction) may mean a thickness direction of the channel layer 132.

The gate electrode 155 may include a conductive material. For example, the gate electrode 155 may include a metal, a metal alloy, a conductive metal nitride, a metal silicide, a doped semiconductor material, a conductive metal oxide, or a conductive metal nitride oxide, or the like. For example, the gate electrode 155 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode 155 may be formed in a single layer or multiple layers.

In some implementations, a hard mask layer located on the gate electrode 155 may be further included. The hard mask layer may be a hard mask used when patterning the gate semiconductor material layer 152a (see FIG. 15) and the gate electrode material layer 155a (see FIG. 15) during the process of forming the gate electrode 155. However, the hard mask layer may be removed depending on the etch condition or the cleaning condition after etching when etching the gate electrode material layer. For example, the hard mask layer may include silicon oxide, silicon nitride, silicon nitride oxide (silicon oxynitride), or a combination thereof.

The gate semiconductor layer 152 may be located between the barrier layer 136 and the gate electrode 155. For example, the gate semiconductor layer 152 may be located on the barrier layer 136, and the gate electrode 155 may be located on the gate semiconductor layer 152. The gate electrode 155 may be in Schottky contact or ohmic contact with the gate semiconductor layer 152. The gate semiconductor layer 152 may overlap with the gate electrode 155 in the third direction (Z direction). At this time, the gate semiconductor layer 152 may completely overlap with the gate electrode 155 in the third direction (Z direction), and an upper surface of the gate semiconductor layer 152 may be entirely covered by the gate electrode 155. For example, the gate semiconductor layer 152 may have substantially the same planar shape (shape in a plan view) as the gate electrode 155. However, the present disclosure is not limited thereto, and the gate electrode 155 may be located to cover at least a portion of the gate semiconductor layer 152.

The gate semiconductor layer 152 may be located between the source electrode 173 and the drain electrode 175. The gate semiconductor layer 152 may be spaced apart from the source electrode 173 and the drain electrode 175. The gate semiconductor layer 152 may be located closer to the source electrode 173 than the drain electrode 175. For example, a spacing distance between the gate semiconductor layer 152 and the source electrode 173 may be smaller than a spacing distance between the gate semiconductor layer 152 and the drain electrode 175, but is not limited thereto.

In some implementations, the gate semiconductor layer 152 may overlap with the gate electrode 155 in the third direction (Z direction). For example, the gate semiconductor layer 152 may completely overlap with the gate electrode 155 in the third direction (Z direction). For example, a side surface of the gate semiconductor layer 152 may be aligned with a side surface of the gate electrode 155. However, the present disclosure is not limited thereto, and the gate semiconductor layer 152 may partially overlap with the gate electrode 155.

The gate semiconductor layer 152 may include one or more materials selected from Group III-V materials, for example, nitrides containing Al, Ga, In, B, or a combination thereof. The gate semiconductor layer 152 may be AlₓIn_{y}Ga_{1-x-y}N (0≤x≤1, 0≤y≤1, x+y≤1). For example, the gate semiconductor layer 152 may include AIN, GaN, InN, InGaN, AlGaN, AlInN, AlInGaN, or a combination thereof. The gate semiconductor layer 152 may include a material having a different energy band gap from the barrier layer 136. For example, the gate semiconductor layer 152 may include GaN, and the barrier layer 136 may include AlGaN. The gate semiconductor layer 152 may be doped with predetermined impurities. For example, the impurity doped into the gate semiconductor layer 152 may be a p-type dopant that may provide holes. For example, the gate semiconductor layer 152 may include GaN doped with p-type impurities. That is, the gate semiconductor layer 152 may be formed as a p-GaN layer. However, the gate semiconductor layer 152 is not limited thereto, and for example, the gate semiconductor layer 152 may be a p-AlGaN layer. As another example, the gate semiconductor layer 152 may be formed as a multilayer including a p-GaN layer and a p-AlGaN layer.

A depletion region DPR may be formed in the channel layer 132 by the gate semiconductor layer 152. The depletion region DPR may be located within the drift region DTR, and may have a narrower width than the drift region DTR. As the gate semiconductor layer 152 having a different energy band gap from the barrier layer 136 is located on the barrier layer 136, an energy band level of a portion of the barrier layer 136 overlapping with the gate semiconductor layer 152 may increase. Accordingly, the depletion region DPR may be formed in the region of the channel layer 132 overlapping with or adjacent to the gate semiconductor layer 152. The depletion region DPR may be a region in a channel path of the channel layer 132 in which the two-dimensional electron gas 134 is not formed or that may have a lower electron concentration than the remaining regions. That is, the depletion region DPR may mean a region in which the flow of the two-dimensional electron gas 134 is interrupted within the drift region DTR. As the depletion region DPR is generated, no current flows between the source electrode 173 and the drain electrode 175, and the channel path may be blocked. Accordingly, the semiconductor device may have normally-off characteristics.

For example, the semiconductor device may be a normally-off high electron mobility transistor (HEMT). As shown in FIG. 1, in a normal state in which a voltage is not applied to the gate electrode 155, the depletion region DPR may exist, and the semiconductor device may be in an off-state. As shown in FIG. 2, when a voltage higher than the threshold voltage is applied to the gate electrode 155, the depletion region DPR may disappear, and the 2-dimensional electron gas 134 may be continued without being interrupted in the drift region DTR. That is, the 2-dimensional electron gas 134 may be formed throughout the channel path (e.g., continuously) between the source electrode 173 and the drain electrode 175, and the semiconductor device may be in an on-state.

In summary, the semiconductor device may include semiconductor layers having different electrical polarization characteristics, and a semiconductor layer having a relatively large polarization rate may cause the 2-dimensional electron gas 134 in another semiconductor layer with which the semiconductor layer forms a heterojunction. The 2-dimensional electron gas 134 may be used as a channel between the source electrode 173 and the drain electrode 175, and continuation or interruption of the flow of the 2-dimensional electron gas 134 may be controlled by the bias voltage applied to the gate electrode 155. In the gate-off state, the flow of the 2-dimensional electron gas 134 is blocked, and thereby a current may not flow between the source electrode 173 and the drain electrode 175. In the gate-on state, as the flow of the 2-dimensional electron gas 134 continues, a current may flow between the source electrode 173 and the drain electrode 175.

A case in which a semiconductor device is a normally-off high electron mobility transistor was described in the above, but the present disclosure is not limited thereto. For example, the semiconductor device may be a normally-on high electron mobility transistor. In the case of a normally-on high electron mobility transistor, the gate semiconductor layer 152 may be omitted, and accordingly, the gate electrode 155 may be located directly on the barrier layer 136. For example, the gate electrode 155 may be in contact with the barrier layer 136. However, the present disclosure is not limited thereto, and a gate insulation layer may be further located between the gate electrode 155 and the barrier layer 136. The insulation layer may be formed as a single layer or a multilayer. The gate insulation layer may completely overlap with the gate electrode 155 in the third direction (Z direction), but is not limited thereto.

In such a structure, the 2-dimensional electron gas 134 may be used as a channel in a state in which a voltage is not applied to the gate electrode 155, and a current flow may occur between the source electrode 173 and the drain electrode 175. In addition, when a negative voltage is applied to the gate electrode 155, the depletion region DPR where the flow of the 2-dimensional electron gas 134 is interrupted may occur in a lower portion of the gate electrode 155. As such, it will be understood that the present disclosure applied equally to normally-on devices.

The seed layer 121, the superlattice layer 124, the high-resistance layer 126, the channel layer 132, the barrier layer 136, and the gate semiconductor layer 152, described above, may be sequentially stacked on the substrate 110. In the semiconductor device, at least one of the seed layer 121, the superlattice layer 124, the high-resistance layer 126, the channel layer 132, the barrier layer 136, and the gate semiconductor layer 152 may be omitted. The seed layer 121, the superlattice layer 124, the high-resistance layer 126, the channel layer 132, the barrier layer 136, and the gate semiconductor layer 152 may be made of the same base semiconductor material, and the material composition ratios of respective layers may be different in consideration of the role of respective layers, the performance required for the semiconductor device, or the like.

The protective layer 500 may be located on the barrier layer 136 and the gate electrode 155. The protective layer 500 may cover an upper surface and the side surface of the gate electrode 155, and the side surface of the gate semiconductor layer 152. A lower surface of the protective layer 500 may be in contact with the barrier layer 136 and the gate electrode 155. Accordingly, the barrier layer 136, the gate semiconductor layer 152, and the gate electrode 155 may be protected by the protective layer 500.

The protective layer 500 of the semiconductor device may include the first protective layer 510 and a second protective layer 520 located on the first protective layer 510.

The first protective layer 510 may be located on the barrier layer 136 and the gate electrode 155. For example, the first protective layer 510 may be located directly on the upper surface 136_U the of barrier layer 136. The first protective layer 510 may cover the upper surface and the side surface of the gate electrode 155, and the side surface of the gate semiconductor layer 152. A lower surface of the first protective layer 510 may be in contact with the upper surface 136_U of the barrier layer 136 and the side surface of the gate electrode 155, an upper surface of the gate electrode 155. For example, the lower surface of the first protective layer 510 may be in contact with the implant region 136a of the barrier layer 136. Accordingly, the barrier layer 136, the gate semiconductor layer 152, and the gate electrode 155 may be protected by the first protective layer 510. However, the present disclosure is not limited thereto, and, for example, the gate electrode 155 may penetrate the first protective layer 510 to be connected to the gate semiconductor layer 152, and the first protective layer 510 may not cover the upper surface of the gate electrode 155. As another example, the lower surface of the first protective layer 510 may be in contact with the gate semiconductor layer 152.

In addition, the first protective layer 510 may be located on the side surface of the source electrode 173 and the side surface of the drain electrode 175. For example, the first protective layer 510 may cover at least a portion of the side surface of the source electrode 173 and the side surface of the drain electrode 175.

The first protective layer 510 may include deuterium (D). The first protective layer 510 may be formed of a first insulating material containing deuterium (D). For example, the first insulating material may include an oxide, such as silicon oxide (SiO₂) or aluminum oxide (Al₂O₃), into which deuterium (D) is implanted, but is not limited thereto. As another example, the first protective layer 510 may include a nitride such as silicon nitride (SiN) or an oxynitride such as silicon oxynitride (SiON), into which deuterium (D) is implanted.

This may be due to the process characteristics of forming the first protective layer 510 on the barrier layer 136 and the gate electrode 155, and performing high-pressure deuterium (HPD) annealing on the first protective layer 510 and the barrier layer 136. Specifically, in the process of patterning the gate semiconductor layer 152 and the gate electrode 155 by patterning the gate semiconductor material layer 152a (see FIG. 15) and the gate electrode material layer 155a (see FIG. 15) located on the barrier layer 136 and the process of forming the first protective layer 510 on the exposed barrier layer 136, a defect such as a vacancy, a dangling bond DB (see FIG. 16), or the like may occur in the first protective layer 510 and the barrier layer 136. According to some implementations of the present disclosure, as the high-pressure deuterium (HPD) annealing is performed on the first protective layer 510 and the barrier layer 136 after forming the first protective layer 510, deuterium (D) may be implanted into the vacancy and/or the dangling bond DB (see FIG. 16) in the first protective layer 510 and the barrier layer 136. That is, the first protective layer 510 may be formed of a material containing deuterium (D). Accordingly, the reliability of the semiconductor device may be improved.

Deuterium (D) may have a stronger bonding force with silicon (Si), compared to protium (H). Accordingly, when the first protective layer 510 of the semiconductor device includes silicon oxide (SiO₂), a bonding force between deuterium (D) and silicon (Si) is greater than the bonding force between protium (H) and silicon (Si), and accordingly, deuterium (D) may bond relatively easily with surrounding atoms in the first protective layer 510.

In some implementations, a content (at%) of deuterium (D) of the first protective layer 510 may differ as a function of distance away from the upper surface 136_U of the barrier layer 136. For example, the content (at%) of deuterium (D) of the first protective layer 510 may increase away from the upper surface 136_U of the barrier layer 136, but the content is not limited thereto. In addition, the content (at%) of deuterium (D) of the first protective layer 510 may be different from a content (at%) of deuterium (D) of the barrier layer 136. This will be described later with reference to FIG. 3 to FIG. 5.

In some implementations, a thickness of the first protective layer 510 along the third direction (Z direction) may be smaller than a thickness of the second protective layer 520 along the third direction (Z direction). For example, the thickness of the first protective layer 510 along the third direction (Z direction) may be 200 nm or less. The thickness of the first protective layer 510 in the third direction (Z direction) may be 100nm or less. By performing high-pressure deuterium (HPD) annealing on the first protective layer 510 and the barrier layer 136 with the thickness of the first protective layer 510 in such a range, deuterium (D) may be easily implanted into the first protective layer 510 and the barrier layer 136.

The second protective layer 520 may be located on the first protective layer 510. The second protective layer 520 may be located directly on the first protective layer 510. The second protective layer 520 may cover the first protective layer 510. The second protective layer 520 may be located between the first protective layer 510 and a field dispersion layer 177 to be described later. A lower surface of the second protective layer 520 may be in contact with the first protective layer 510, and an upper surface of the second protective layer 520 may be in contact with the field dispersion layer 177 to be described later. In addition, the second protective layer 520 may be located on the side surface of the source electrode 173 and the side surface of the drain electrode 175. That is, the second protective layer 520 may cover at least a portion of the side surface of the source electrode 173 and the side surface of the drain electrode 175.

The second protective layer 520 may include a different insulating material from the first protective layer 510. The second protective layer 520 may be formed of a second insulating material that does not contain deuterium (D), e.g., is substantially free of deuterium (D). For example, the second insulating material may include silicon nitride (SiN) or silicon oxynitride (SiON) that does not contain deuterium (D), but is not limited thereto. As another example, the second insulating material may include an oxide, such as silicon oxide (SiO₂) or aluminum oxide (Al₂O₃), that does not contain deuterium (D). Here, that the second protective layer 520 does not contain deuterium (D) may mean a result caused as the high-pressure deuterium (HPD) annealing process is not performed on the second protective layer 520. That is, the high-pressure deuterium (HPD) annealing process may be performed before the process of forming the second protective layer 520, and accordingly, deuterium (D) may not be implanted into the material constituting the second protective layer 520.

It will be understood that trace amounts of deuterium may be present in a layer that does not contain or is substantially free of deuterium (e.g., as a result of diffusion from an adjacent layer having deuterium, separate from implanting deuterium in an HPD annealing process), without departing from the scope of this disclosure.

In some implementations, the thickness of the second protective layer 520 along the third direction (Z direction) may be greater than the thickness of the first protective layer 510 along the third direction (Z direction). Accordingly, after the high-pressure deuterium (HPD) annealing process is performed on the first protective layer 510 and the barrier layer 136, the second protective layer 520 is formed in a sufficient thickness, and therefore, the barrier layer 136, the gate semiconductor layer 152, and the gate electrode 155 may be effectively protected.

In FIG. 1 and FIG. 2, it was illustrated that the second protective layer 520 is formed as a single layer, but it is not limited thereto, the second protective layer 520 may be formed as two or more layers.

In FIG. 1 and FIG. 2, it was illustrated that the protective layer 500 is formed as a bilayer, but it is not limited thereto, the protective layer 500 may be formed as three or more layers or in a single layer.

The source electrode 173 and the drain electrode 175 may be located on the channel layer 132. The source electrode 173 and the drain electrode 175 may be in direct contact with the channel layer 132, and may be electrically connected to the channel layer 132.

The source electrode 173 and the drain electrode 175 may extend in a second direction (Y direction). The source electrode 173 and the drain electrode 175 may be spaced apart from each other, and the gate electrode 155 and the gate semiconductor layer 152 may be located between the source electrode 173 and the drain electrode 175. The gate electrode 155 and the gate semiconductor layer 152 may be spaced apart from the source electrode 173 and the drain electrode 175. For example, the source electrode 173 may be electrically connected to the channel layer 132 on a first side of the gate electrode 155, and the drain electrode 175 may be electrically connected to the channel layer 132 on a second side of the gate electrode 155. The source electrode 173 and the drain electrode 175 may be located outside the drift region DTR of the channel layer 132. An interface between the source electrode 173 and the channel layer 132 may be a first side edge of the drift region DTR. In the same way, an interface between the drain electrode 175 and the channel layer 132 may be a second side edge of the drift region DTR.

However, the arrangement is not limited thereto, and the channel layer 132 may not be recessed, and the source electrode 173 and the drain electrode 175 may be located on the upper surface 132_U of the channel layer 132 and the upper surface 136_U of the barrier layer 136. A bottom surface of the source electrode 173 and the drain electrode 175 may be in contact with the upper surface 132_U of the channel layer 132. A portion of the channel layer 132 and the barrier layer 136 in contact with the source electrode 173 and the drain electrode 175 may be doped at a high concentration. Accordingly, the carrier having passed through the 2-dimensional electron gas 134 may pass through a portion of the channel layer 132 doped at a high concentration, i.e., an upper portion of the 2-dimensional electron gas 134, and then be transferred to the source electrode 173 and the drain electrode 175. The source electrode 173 and the drain electrode 175 may not be in direct contact with the 2-dimensional electron gas 134 in a horizontal direction. Here, the horizontal direction may mean a direction parallel to the upper surface 136_U of the channel layer 132 or the barrier layer 136.

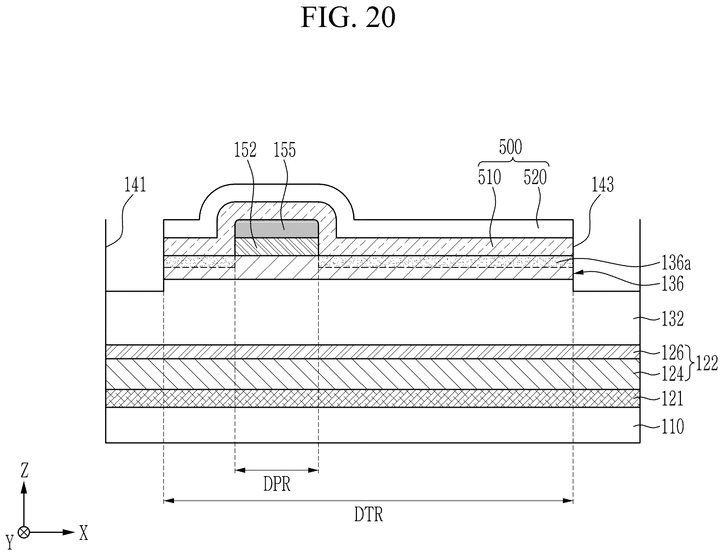

In more detail, trenches 141 and 143 (see FIG. 20) that penetrate the protective layer 500 and the barrier layer 136 and recess the upper surface 132_U of the channel layer 132 may be located on opposite sides of the gate electrode 155 to be spaced apart from each other. The source electrode 173 and the drain electrode 175 may be located within the trenches 141 and 143 (see FIG. 20) located on opposite sides of the gate electrode 155, respectively. The source electrode 173 and the drain electrode 175 may be formed to fill the trenches 141 and 143 (see FIG. 20). Within the trench 141, 143, the source electrode 173 and the drain electrode 175 may be in contact with the channel layer 132 and the barrier layer 136. The channel layer 132 may form a bottom surface and a side wall of the trenches 141 and 143, and the barrier layer 136 may form a side wall of the trenches 141 and 143. In addition, the source electrode 173 and the drain electrode 175 may be in contact with a side surface of the barrier layer 136. That is, the source electrode 173 and the drain electrode 175 may cover side surfaces of the channel layer 132 and the barrier layer 136.

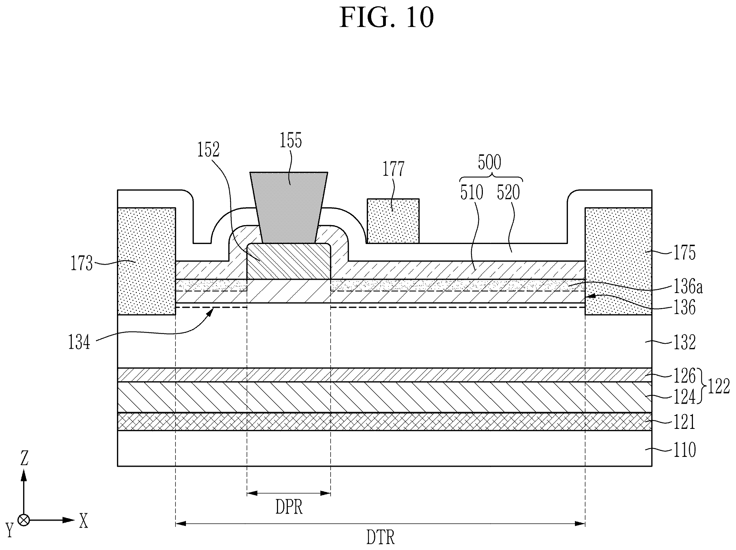

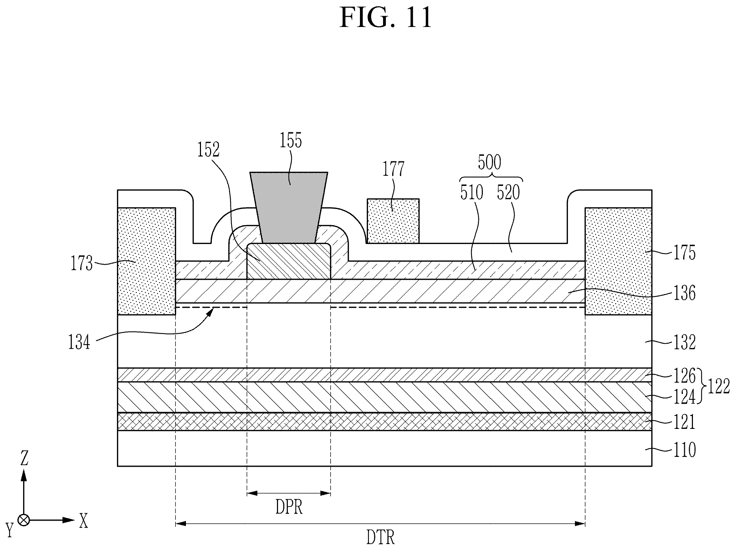

In some implementations, the source electrode 173 and the drain electrode 175 may cover at least a portion of a side surface of the protective layer 500. For example, the source electrode 173 and the drain electrode 175 may cover the side surface of the protective layer 500. An upper surface of the source electrode 173 and the drain electrode 175 may protrude more than an upper surface of the protective layer 500. In addition, at least one of the source electrode 173 and the drain electrode 175 may cover at least a portion of the upper surface of the protective layer 500. However, the present disclosure is not limited thereto, and the source electrode 173 and the drain electrode 175 may cover at least a portion of the side surface of the protective layer 500, and may not cover a remaining portion of the side surface of the protective layer 500. In this case, a remaining portion of the protective layer 500 may be located on the upper surface of the source electrode 173 and the drain electrode 175. This will be later described in detail with reference to FIG. 10 and FIG. 11.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, or a conductive metal nitride oxide, or the like. For example, the source electrode 173 and the drain electrode 175 may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The source electrode 173 and the drain electrode 175 may be formed in a single layer or multiple layers. The source electrode 173 and the drain electrode 175 may be in ohmic contact with the channel layer 132. A region in contact with the source electrode 173 and the drain electrode 175 in the channel layer 132 may be doped at a relatively high concentration compared to other regions.

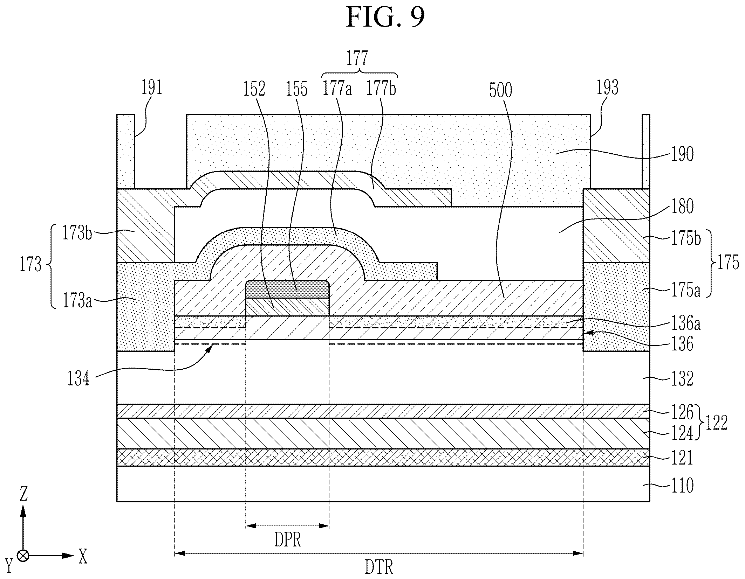

FIG. 1 and FIG. 2 illustrate that the semiconductor device includes one pair of source electrode 173 and the drain electrode 175, but the number of the source electrodes 173 and the drain electrodes 175 is not limited thereto. For example, the source electrode 173 may include a plurality of source electrodes sequentially stacked on the channel layer 132 in the third direction (Z direction), and the drain electrode 175 may include a plurality of drain electrodes sequentially stacked on the channel layer 132 in the third direction (Z direction). This configuration will be later described in detail with reference to FIG. 9.

The field dispersion layer 177 may be located between the gate electrode 155 and the drain electrode 175. The field dispersion layer 177 may be located between the source electrode 173 and the drain electrode 175. The field dispersion layer 177 may be located on the protective layer 500. For example, the field dispersion layer 177 may be located on the second protective layer 520. That is, the second protective layer 520 may be located between the first protective layer 510 and the field dispersion layer 177. The field dispersion layer 177 may overlap with the channel layer 132 in the third direction (Z direction).

The field dispersion layer 177 may include the same material as the source electrode 173, and may be located on the same layer as the source electrode 173. The field dispersion layer 177 may be simultaneously formed with the source electrode 173 in the same process. For example, a boundary between the field dispersion layer 177 and the source electrode 173 may not be clear, and the field dispersion layer 177 may be integrally formed with the source electrode 173. However, the configuration is not limited thereto, and the field dispersion layer 177 may be a separate component separated from the source electrode 173. In addition, the field dispersion layer 177 may be located in a different layer from the source electrode 173, and may be formed in a different process.

The field dispersion layer 177 may serve to disperse an electric field concentrated around the gate electrode 155. For example, in the gate-off state, the 2-dimensional electron gas 134 may be located at a very high concentration in a portion of the channel layer 132 located between the gate electrode 155 and the source electrode 173 and in a portion of the channel layer 132 located between the gate electrode 155 and the drain electrode 175. In this case, the electric field may be concentrated on the gate electrode 155 or the gate semiconductor layer 152. Meanwhile, the gate electrode 155 and the gate semiconductor layer 152 are vulnerable to electric fields, so when electric fields are concentrated, the leakage current may increase, and the breakdown voltage of the semiconductor device may decrease. At this time, the electric field concentrated around the gate electrode 155 or the gate semiconductor layer 152 may be dispersed by the field dispersion layer 177, so that the leakage current may be decreased and the breakdown voltage may be increased.

FIG. 1 and FIG. 2 illustrate that the semiconductor device includes one field dispersion layer 177, but the number of the field dispersion layers 177 is not limited thereto. For example, the field dispersion layer 177 may include a plurality of field dispersion layers located on the protective layer 500. As another example, a plurality of protective layers may be located on the protective layer 500, and the plurality of field dispersion layers located on different protective layers may be included.

The barrier layer 136 of the semiconductor device may include the implant region 136a containing deuterium (D), and the first protective layer 510 may contain deuterium (D). Accordingly, a defect generated in the process of forming the barrier layer 136 and the first protective layer 510, such as a vacancy, a dangling bond DB, or the like, may be improved by bonding with deuterium (D). Deuterium (D) may be implanted through the high-pressure deuterium (HPD) annealing process on the first protective layer 510 and the barrier layer 136. Accordingly, the reliability of a semiconductor device may be improved.

Hereinafter, the barrier layer and the protective layer of a semiconductor device according to some implementations of the present disclosure will be described with further reference to FIG. 3, FIGS. 4A to 4D, and FIG. 5.

FIG. 3, FIGS. 4A to 4D, and FIG. 5 are graphs showing a deuterium content in the barrier layer and the protective layer of the semiconductor device. As described above, the implant region 136a and the first protective layer 510 of the barrier layer 136 may include deuterium (D), and the second protective layer 520 may not contain deuterium (D).

First, further referring to FIG. 3, a first content (at%) of deuterium (D) of the implant region 136a of the barrier layer 136 of the semiconductor device may increase away from the upper surface 132_U of the channel layer 132. For example, the first content (at%) of deuterium (D) at a lower surface of the implant region 136a may have a minimum value N1min, and the first content (at%) of deuterium (D) at the upper surface of the implant region 136a may have a maximum value N1max. A rate at which the first content (at%) of deuterium (D) of the implant region 136a increases per unit distance may increase away from the upper surface 132_U of the channel layer 132. Here, a rate at which the first content (at%) of deuterium (D) of the implant region 136a increases per unit distance may mean the amount of change in the content per amount of change of the distance in in a vertical direction (e.g., a thickness direction of the channel layer 132, which is hereinafter referred to as 'third direction (Z direction)'). For example, the first content (at%) of deuterium (D) of the implant region 136a may exponentially increase away from the upper surface 132_U of the channel layer 132. However, the present disclosure is not limited thereto, and the rate at which the first content (at%) of deuterium (D) of the implant region 136a increases per unit distance may be constant, or may decrease away from the upper surface 132_U of the channel layer 132. As another example, the rate at which the first content (at%) of deuterium (D) of implant region 136a per unit distance increases may be constant.

In addition, a second content (at%) of deuterium (D) of the first protective layer 510 may increase away from the upper surface 132_U of the channel layer 132. That is, the second content (at%) of deuterium (D) of the first protective layer 510 may increase away from the upper surface 136_U of the barrier layer 136. For example, the second content (at%) of deuterium (D) at the lower surface of the first protective layer 510 may have a minimum value N2min, and the second content (at%) of deuterium (D) at an upper surface 510_U of the first protective layer 510 may have a maximum value N2max. A rate at which the second content (at%) of deuterium (D) of the first protective layer 510 increases per unit distance may increase away from the upper surface 132_U of the channel layer 132. However, the present disclosure is not limited thereto, and a ratio in which the second content (at%) of deuterium (D) of the first protective layer 510 increases per unit distance may be constant, or may decrease away from the upper surface 132_U of the channel layer 132.

In some implementations, the second content (at%) of deuterium (D) of the first protective layer 510 may be greater than or equal to than the first content (at%) of deuterium (D) of the implant region 136a. For example, as shown in FIG. 3, the minimum value N2min of the second content (at%) of deuterium (D) included in the first protective layer 510 may be substantially the same as the maximum value N1max of the first content (at%) of deuterium (D) included in the implant region 136a. In addition, the maximum value N2max of the second content (at%) of deuterium (D) included in the first protective layer 510 may be greater than the maximum value N1max of the first content (at%) of deuterium (D) included in the implant region 136a, and the minimum value N2min of the second content (at%) of deuterium (D) included in the first protective layer 510 may be greater than the minimum value N1min of the first content (at%) of deuterium (D) included in the implant region 136a. However, the present disclosure is not limited thereto, and the first content (at%) of deuterium (D) of the implant region 136a may be greater than the second content (at%) of deuterium (D) of the first protective layer 510 at one or more positions of the implant region 136a and the first protective layer 510.

Meanwhile, the second protective layer 520 may not contain deuterium (D). Therefore, the content (at%) of deuterium (D) may non-continuously change at an interface between the first protective layer 510 and the first protective layer 510.

In some implementations, the profile of the first content (at%) of deuterium (D) of the implant region 136a and the second content (at%) of deuterium (D) of the first protective layer 510 may be due to characteristics of the high-pressure deuterium (HPD) annealing process. In FIG. 3, the profile of the first content (at%) of deuterium (D) of the implant region 136a and the second content (at%) of deuterium (D) of the first protective layer 510 was described as an example, but it is not limited thereto.

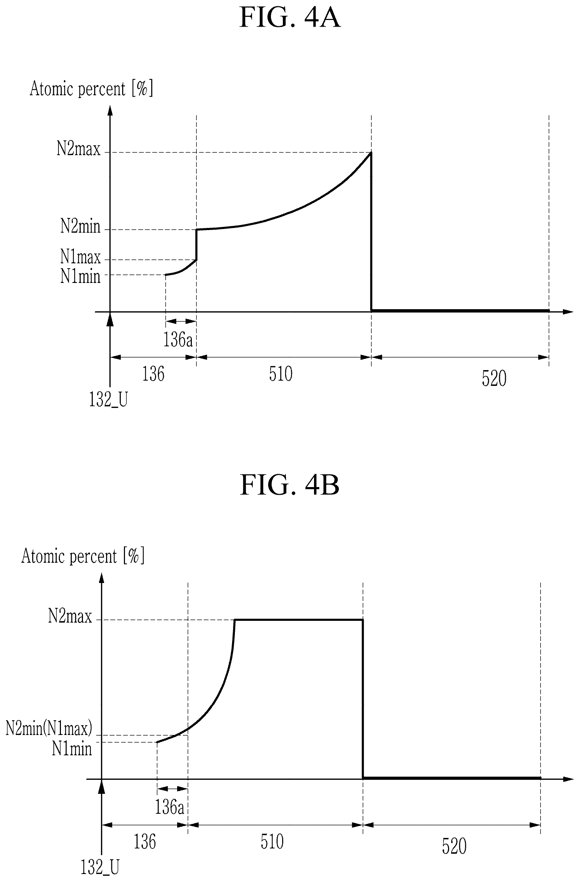

As another example, referring to FIG. 4A, the minimum value N2min of the second content (at%) of deuterium (D) included in the first protective layer 510 may be greater than the maximum value N1max of the first content (at%) of deuterium (D) included in the implant region 136a. For example, a discontinuous change of the second content (at%) of deuterium (D) may occur at the interface between the implant region 136a and the first protective layer 510. In this case, the maximum value N2max of the second content (at%) of deuterium (D) included in the first protective layer 510 may be greater than the maximum value N1max of the first content (at%) of deuterium (D) included in the implant region 136a, and the minimum value N2min of the second content (at%) of deuterium (D) included in the first protective layer 510 may be greater than the minimum value N1min of the first content (at%) of deuterium (D) included in the implant region 136a.

As still another example, referring to FIG. 4B, the first protective layer 510 may include a section where the second content (at%) of deuterium (D) is constant. For example, the second content (at%) of the first protective layer 510 may include a constant section.

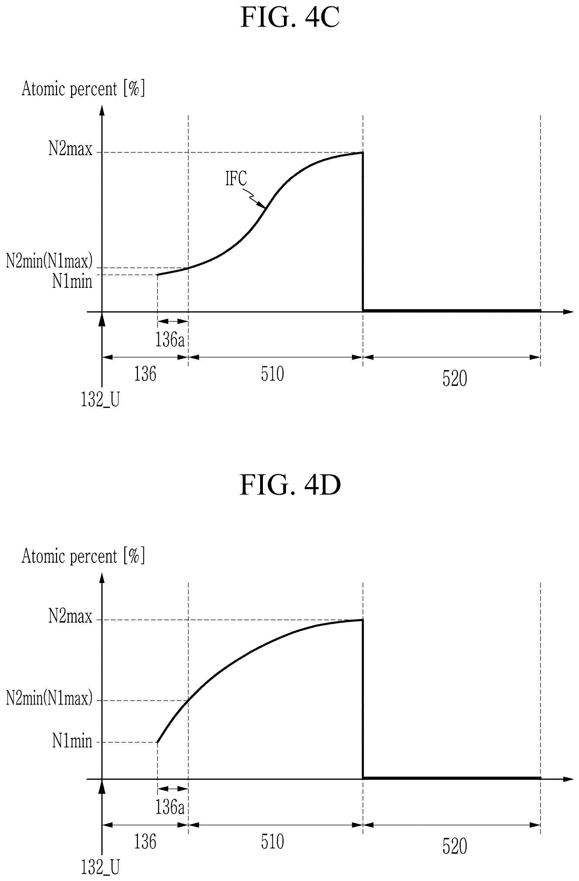

As still another example, referring to Fig. 4C, first protective layer 510 may include an inflection point IFC where a rate of change in the second content (at%) per unit distance changes. For example, first protective layer 510 may include a section where the change in the second content (at%) per unit distance increases and the inflection point IFC after which the rate of change of the second content (at%) per unit distance decreases. Accordingly, the rate at which the second content (at%) of deuterium (D) of the first protective layer 510 changes per unit distance increases and then decreases away from the upper surface 132_U of the channel layer 132.

However, the present disclosure is not limited thereto, and, for example, as shown in FIG. 4D, the rate at which the second content (at%) of deuterium (D) of the first protective layer 510 per unit distance increases may decrease away from the upper surface 132_U of the channel layer 132.

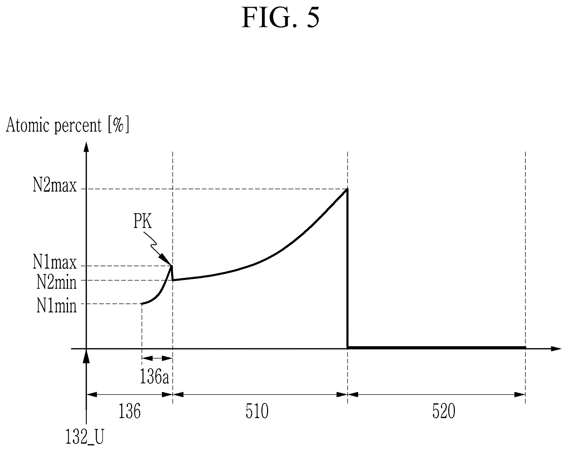

As still another example, referring to FIG. 5, the minimum value N2min of the second content (at%) of deuterium (D) included in the first protective layer 510 may be smaller than the maximum value N1max of the first content (at%) of deuterium (D) included in the implant region 136a. For example, the first content (at%) of deuterium (D) at the upper surface of the implant region 136a may be smaller than the second content (at%) at the lower surface of the first protective layer 510. In this case, deuterium content (at%) may have a peak PK at the interface between the implant region 136a and the first protective layer 510. This may be due to the characteristics of the high-pressure deuterium (HPD) annealing process.

In the example of FIG. 5, the maximum value N2max of the second content (at%) of deuterium (D) included in the first protective layer 510 may be greater than the maximum value N1max of the first content (at%) of deuterium (D) included in the implant region 136a, and the minimum value N2min of the second content (at%) of deuterium (D) included in the first protective layer 510 may be greater than the minimum value N1min of the first content (at%) of deuterium (D) included in the implant region 136a.

However, the present disclosure is not limited to the foregoing examples, and the profile of the first content (at%) of deuterium (D) included in the implant region 136a and the second content (at%) of deuterium (D) included in the first protective layer 510 may be variously changed.

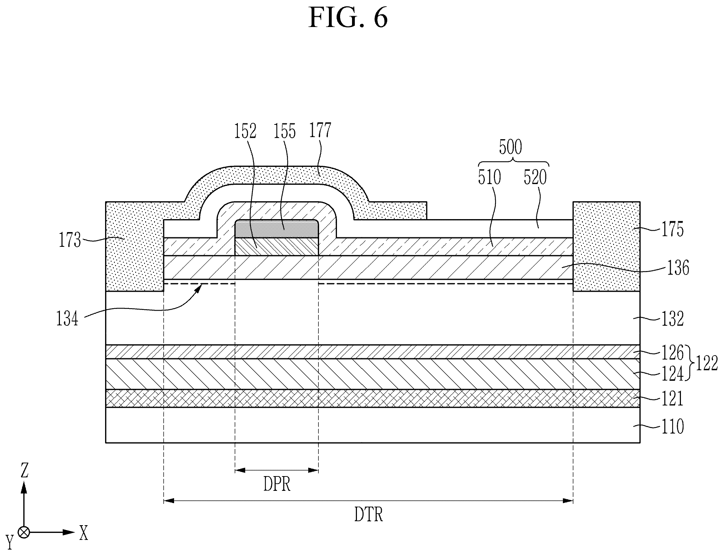

Hereinafter, examples of semiconductor devices, according to some implementations of the present disclosure, will be described with reference to FIG. 6 to FIG. 13. FIG. 6 to FIG. 13 are cross-sectional views showing the semiconductor devices.

FIG. 6 to FIG. 13 show various modified examples of the semiconductor device shown in FIG. 1 to FIG. 5. The examples shown in FIG. 6 to FIG. 13 have substantially the same parts as the example shown in FIG. 1 to FIG. 5, and therefore, a description thereof will be omitted while differences will be mainly described. In addition, same reference numerals will be used for the same components as the previous example. Description provided with respect to FIGS. 1 to 5 applies equally to FIGS. 6 to 13, except where noted otherwise or suggested otherwise by context.

Referring to FIG. 6, the barrier layer 136 of a semiconductor device may not contain deuterium (D). That is, the implant region 136a may not be located in the barrier layer 136. Accordingly, the upper surface 136_U of the barrier layer 136 that does not contain deuterium (D) may be in contact with the first protective layer 510. This may be due to the process characteristics of implanting deuterium (D) only into the first protective layer 510 during the process of performing high-pressure deuterium (HPD) annealing on an interface of the first protective layer 510.

Referring to FIG. 7, the implant region 136a of a semiconductor device may be in contact with the channel layer 132.

In some implementations, a thickness of the implant region 136a along the third direction (Z direction) may be substantially the same as a thickness of the barrier layer 136 along the third direction (Z direction). For example, the lower surface of the implant region 136a may be in contact with the channel layer 132, and the upper surface of the implant region 136a may be in contact with the first protective layer 510. The implant region 136a may be located between the source electrode 173 and the gate electrode 155 and between the drain electrode 175 and the gate electrode 155. Accordingly, the barrier layer 136 may include the implant region 136a containing deuterium (D) and a barrier region 136b that does not contain deuterium (D), and by the barrier region 136b. The portion of the injection region 136a located between the source electrode 173 and the gate electrode 155 and the portion of the injection region 136a located between the drain electrode 175 and the gate electrode 155 may be separated from each other along the first direction (X direction). The electrodes 155, 173, 175 may be spaced apart from one another along a "lateral" direction, that is, along the first direction (X direction) and/or the second direction (Y direction).

In some implementations having the configuration of FIG. 7, it may be understood that the description of the first content (at%) of deuterium (D) described with reference to FIG. 3 to FIG. 5 may be applied to the content (at%) of deuterium (D) included in the implant region 136a.

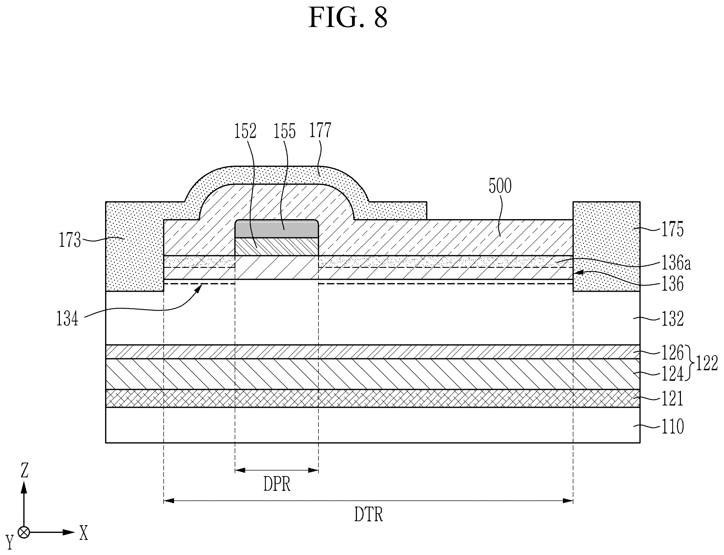

Referring to FIG. 8, the protective layer 500 of a semiconductor device may be formed in a single layer.

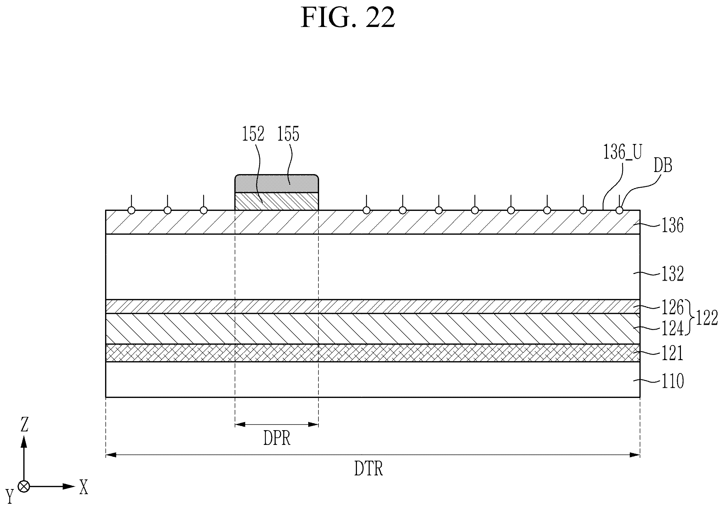

In some implementations, the protective layer 500 may be located on the barrier layer 136. For example, the protective layer 500 may be located directly on the upper surface of the implant region 136a of the barrier layer 136. The protective layer 500 may include the second insulating material that does not contain deuterium (D). For example, the protective layer 500 may include silicon oxide SiO₂, silicon nitride (SiN), silicon nitride oxide (SiON), or a combination thereof that does not contain deuterium (D). Unlike some implementations according to FIG. 1 to FIG. 5, this may be due to the process characteristics of performing the high-pressure deuterium (HPD) annealing process on the upper surface 136_U of the barrier layer 136 exposed after patterning the gate semiconductor material layer 152a (see FIG. 15) and the gate electrode material layer 155a (see FIG. 15) located on the barrier layer 136. Accordingly, the dangling bond DB (see FIG. 16) formed in the upper portion of the barrier layer 136 may be effectively removed. This will be later described in detail with reference to FIG. 22 to FIG. 25.

Referring to FIG. 9, a semiconductor device may further include an upper protective layer 180 located on the protective layer 500. In some implementations (e.g., in conjunction with the upper protective layer 180), the protective layer 500 may be formed as a single layer.

In some implementations, the protective layer 500 may include deuterium (D). The protective layer 500 may be formed of a first insulating material containing deuterium (D). For example, the insulating material may include an oxide, such as silicon oxide (SiO₂) or aluminum oxide (Al₂O₃), into which deuterium (D) is implanted, but is not limited thereto. As another example, the protective layer 500 may include a nitride such as silicon nitride (SiN) or an oxynitride such as silicon oxynitride (SiON), into which deuterium (D) is implanted. In FIG. 9, it was described that the protective layer 500 is formed as a single layer, but is not limited thereto, and like the example of FIG. 1 to FIG. 5, the protective layer 500 may include the first protective layer 510 located on the barrier layer 136 and containing deuterium (D), and the second protective layer 520 that is located on the first protective layer 510 and does not contain deuterium (D).

In some implementations, the upper protective layer 180 may cover the upper surface of the protective layer 500 and an upper surface and a side surface of a first field dispersion layer 177a. In some implementations, the upper protective layer 180 may be formed of the second insulating material that does not contain deuterium (D). For example, the second insulating material may include silicon nitride (SiN) or silicon oxynitride (SiON) that does not contain deuterium (D), but is not limited thereto. As another example, the second insulating material may include an oxide, such as silicon oxide (SiO₂) or aluminum oxide (Al₂O₃), that does not contain deuterium (D). Here, that the upper protective layer 180 does not contain deuterium (D) may result from, the high-pressure deuterium (HPD) annealing process not being performed on the upper protective layer 180, or may mean that the HPD annealing process was not performed on the upper protective layer 180. For example, the high-pressure deuterium (HPD) annealing process may be performed before forming the upper protective layer 180, and accordingly, deuterium (D) may not be implanted into the material constituting the upper protective layer 180.

As shown in FIG. 9, the source electrode 173 and/or the drain electrode 175 of a semiconductor device may be provided in a plural quantity. The source electrode 173 of a semiconductor device may include a first source electrode 173a and a second source electrode 173b sequentially stacked on the channel layer 132 in the third direction (Z direction), and the drain electrode 175 may include a first drain electrode 175a and a second drain electrode 175b sequentially stacked on the channel layer 132 in the third direction (Z direction). The first source electrode 173a and the first drain electrode 175a may penetrate the protective layer 500 and the barrier layer 136 to be connected to the channel layer 132. Each of the second source electrode 173b and the second drain electrode 175b may penetrate the upper protective layer 180 to be connected to the first source electrode 173a and the first drain electrode 175a. Each of the first source electrode 173a and the first drain electrode 175a may include the same material as the second source electrode 173b and the second drain electrode 175b, but may include different materials in some implementations.

The field dispersion layer 177 of a semiconductor device may be provided in a plural quantity. For example, the first field dispersion layer 177a located on the protective layer 500 and a second field dispersion layer 177b located on the upper protective layer 180 may be included. The first field dispersion layer 177a may be located between the protective layer 500 and the upper protective layer 180. The first field dispersion layer 177a may include the same material as the first source electrode 173a. The first field dispersion layer 177a may be formed by the same process as the first source electrode 173a, and located on the same layer as at least a portion of the first source electrode 173a. The second field dispersion layer 177b may be located between the upper protective layer 180 and a capping layer 190. The second field dispersion layer 177b may include the same material as the second source electrode 173b. The second field dispersion layer 177b may be formed by the same process as the second source electrode 173b, and located on the same layer as at least a portion of the second source electrode 173b. However, the present disclosure is not limited thereto, and the field dispersion layers 177a and 177b may be located in a different layer from the source electrodes 173a and 173b, and may be formed in a different process.

As shown in FIG. 9, a semiconductor device according to some implementations may further include the capping layer 190 located on the upper protective layer 180.

At least a portion of upper surfaces and side surfaces of the second source electrode 173b and the second drain electrode 175b may be covered by the capping layer 190. The second field dispersion layer 177b may be covered by the capping layer 190. The capping layer 190 is configured to protect the semiconductor device from external stress, e.g., moisture or the like, and may be located in the uppermost layer of the semiconductor device. For example, the capping layer 190 may be located outermost in the semiconductor device. The source electrode 173 and the drain electrode 175 may be connected to the external wiring, and for connection to the wiring, the capping layer 190 may include pad opening portions 191 and 193. A first pad opening portion 191 overlapping with at least a portion of the source electrode 173 may be formed in the capping layer 190. By the first pad opening portion 191, the upper surface of the source electrode 173 may be externally exposed. Although not shown in the drawings, a wire electrically connected to the source electrode 173 through the first pad opening portion 191 may be further formed. A second pad opening portion 193 overlapping with at least a portion of the drain electrode 175 may be formed in the capping layer 190. By the second pad opening portion 193, an upper surface of the drain electrode 175 may be externally exposed. Although not shown in the drawings, a wire electrically connected to the drain electrode 175 through the second pad opening portion 193 may be further formed.

The capping layer 190 may include an insulating material. For example, the capping layer 190 may include a material such as polyimide (PI), SiO₂, SiN, SiON, or the like. The capping layer 190 may be formed in a single layer or multiple layers.

Referring to FIG. 10 and FIG. 11, the gate electrode 155 of a semiconductor device according to some implementations may penetrate the protective layer 500 to be connected to the gate semiconductor layer 152.

In some implementations, the gate electrode 155 may penetrate the protective layer 500. For example, the gate electrode 155 may penetrate the first and second protective layers 510 and 520 on the gate semiconductor layer 152. Accordingly, at least a portion of the side surface of the gate electrode 155 may be in contact with the protective layer 500. The gate electrode 155 may overlap with the gate semiconductor layer 152 in the third direction (Z direction). A lower surface of the gate electrode 155 may be in contact with the upper surface of the gate semiconductor layer 152. The gate electrode 155 may be located on at least a portion of the gate semiconductor layer 152. For example, the gate electrode 155 may be located on a portion of the gate semiconductor layer 152, and the first protective layer 510 may be located on a remaining portion of the gate semiconductor layer 152. For example, the upper surface of the gate semiconductor layer 152 may be in contact with the gate electrode 155 and the first protective layer 510. However, the present disclosure is not limited thereto, and the gate semiconductor layer 152 may completely overlap with the gate electrode 155.

In some implementations, the protective layer 500 may cover at least a portion of the barrier layer 136 and the gate semiconductor layer 152. In addition, the field dispersion layer 177 may be located on the protective layer 500. For example, the field dispersion layer 177 may be located between the gate electrode 155 and the drain electrode 175. The field dispersion layer 177 may be connected to the gate electrode 155 or connected to the source electrode 173. However, the present disclosure is not limited thereto, and the field dispersion layer 177 may not be connected to the gate electrode 155 and the source electrode 173. In addition, the field dispersion layer 177 may extend in one direction. For example, the field dispersion layer 177 may extend in a direction parallel to the gate electrode 155, the source electrode 173, and the gate electrode 155.

In this case, as shown in FIG. 10, the barrier layer 136 may include the implant region 136a containing deuterium (D). However, the present disclosure is not limited thereto, and as shown in FIG. 11, the barrier layer 136 may not include the implant region 136a containing deuterium (D).

In configurations as shown in FIG. 10 and FIG. 11, the high-pressure deuterium (HPD) annealing process may be performed on at least a partial region of the barrier layer 136 and the first protective layer 510, and accordingly, at least a partial region of the first protective layer 510 and/or the barrier layer 136 may include deuterium (D), and the second protective layer 520 may not contain deuterium (D). A description thereof will be omitted since it is substantially the same as the example of FIG. 1 to FIG. 5.

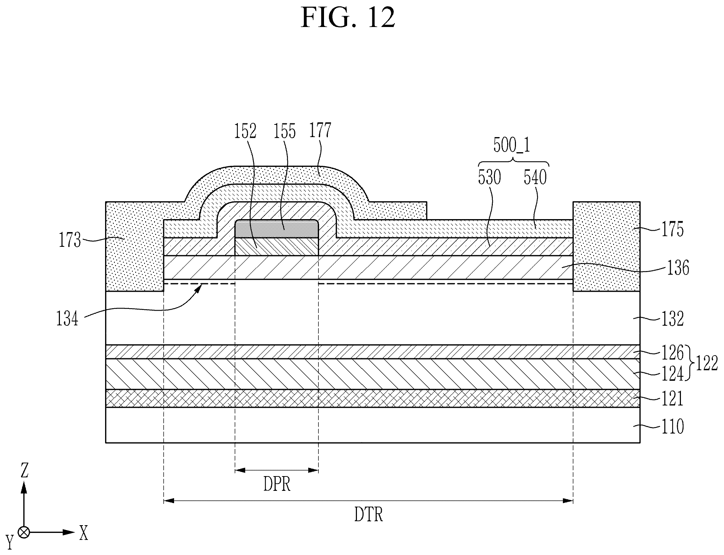

Referring to FIG. 12, a protective layer 500_1 of a semiconductor device according to some implementations may include a third protective layer 530 that is located on the barrier layer 136 and does not contain deuterium (D) and a fourth protective layer 540 located on the third protective layer 530 and containing deuterium (D).

In some implementations, the third protective layer 530 may be located on the barrier layer 136 and the gate electrode 155. For example, the third protective layer 530 may be located directly on the upper surface 136_U the of barrier layer 136. The third protective layer 530 may cover the upper surface and the side surface of the gate electrode 155, and the side surface of the gate semiconductor layer 152. A lower surface of the third protective layer 530 may be in contact with the upper surface 136_U of the barrier layer 136 and the side surface of the gate electrode 155, the upper surface of the gate electrode 155. For example, the lower surface of the third protective layer 530 may be in contact with the implant region 136a of the barrier layer 136. Accordingly, the barrier layer 136, the gate semiconductor layer 152, and the gate electrode 155 may be protected by the third protective layer 530. However, the present disclosure is not limited thereto, and the gate electrode 155 may penetrate the third protective layer 530 to be connected to the gate semiconductor layer 152, and the third protective layer 530 may not cover the upper surface of the gate electrode 155. Alternatively, or in addition, the lower surface of the third protective layer 530 may be in contact with the gate semiconductor layer 152. In addition, the third protective layer 530 may be located on the side surface of the source electrode 173 and the side surface of the drain electrode 175. For example, the third protective layer 530 may cover at least a portion of the side surface of the source electrode 173 and the side surface of the drain electrode 175.

The third protective layer 530 may be formed of an insulating material that does not contain deuterium (D). For example, the third protective layer 530 may include an oxide, such as silicon oxide (SiO₂) or aluminum oxide (Al₂O₃), that does not contain deuterium (D). However, the present disclosure is not limited thereto, and as another example, the third protective layer 530 may include a nitride such as silicon nitride (SiN) or an oxynitride such as silicon oxynitride (SiON), that does not contain deuterium (D).

The fourth protective layer 540 may be located on the third protective layer 530. The fourth protective layer 540 may be located directly on the third protective layer 530. The fourth protective layer 540 may cover the third protective layer 530. The fourth protective layer 540 may be located between the third protective layer 530 and the field dispersion layer 177 to be described later. A lower surface of the fourth protective layer 540 may be in contact with the third protective layer 530, and an upper surface of the fourth protective layer 540 may be in contact with the field dispersion layer 177. In addition, the fourth protective layer 540 may be located on the side surface of the source electrode 173 and the side surface of the drain electrode 175. That is, the fourth protective layer 540 may cover at least a portion of the side surface of the source electrode 173 and the side surface of the drain electrode 175.

In some implementations, the fourth protective layer 540 may include a different insulating material from the third protective layer 530. The fourth protective layer 540 may be formed of an insulating material containing deuterium (D). For example, the fourth protective layer 540 may include silicon nitride (SiN) or silicon oxynitride (SiON) containing deuterium (D), but is not limited thereto. As another example, the fourth protective layer 540 may include an oxide such as silicon oxide (SiO₂) or aluminum oxide (Al₂O₃), that contains deuterium (D). In some implementations, the content (at%) of deuterium (D) of the fourth protective layer 540 may differ as a function of distance away from the upper surface 136_U of the barrier layer 136, but is not limited thereto.

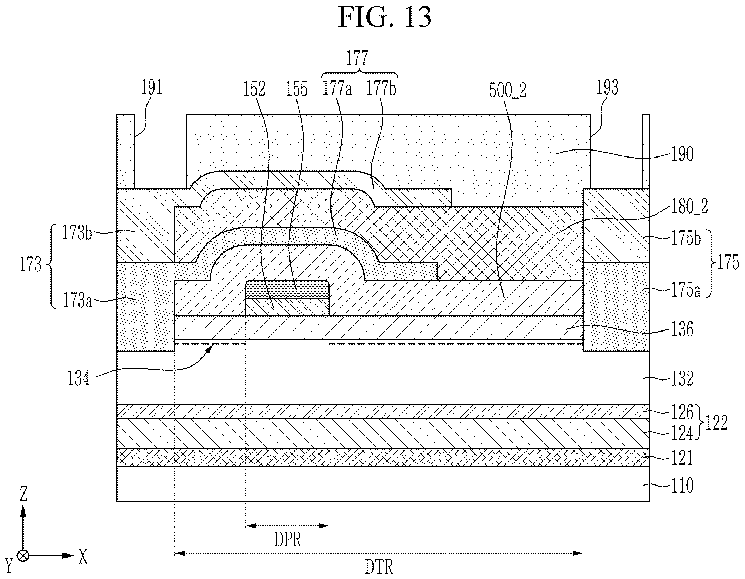

The example shown in FIG. 13 has substantially the same parts as the example shown in FIG. 9, and therefore, a description thereof will be omitted while differences will be mainly described. In addition, same reference numerals will be used for the same components as the previous example.

Referring to FIG. 13, a protective layer 500_2 of a semiconductor device may be formed as a single layer. In some implementations, the protective layer 500_2 may be formed of an insulating material that does not contain deuterium (D). For example, the protective layer 500_2 may include an oxide, such as silicon oxide (SiO₂) or aluminum oxide (Al₂O₃), that does not contain deuterium (D). However, the present disclosure is not limited thereto, and as another example, the protective layer 500_2 may include a nitride such as silicon nitride (SiN) or an oxynitride such as silicon oxynitride (SiON), that does not contain deuterium (D).

In some implementations, the upper protective layer 180_2 may include a different insulating material from the protective layer 500_2. The upper protective layer 180_2 may be formed of an insulating material containing deuterium (D). For example, the upper protective layer 180_2 may include silicon nitride (SiN) or silicon oxynitride (SiON) containing deuterium (D), but is not limited thereto. As another example, the upper protective layer 180_2 may include an oxide such as silicon oxide (SiO₂) or aluminum oxide (Al₂O₃), that contains deuterium (D). In some implementations, the content (at%) of deuterium (D) of the upper protective layer 180_2 may differ as a function of distance away from the upper surface 136_U of the barrier layer 136, but is not limited thereto.

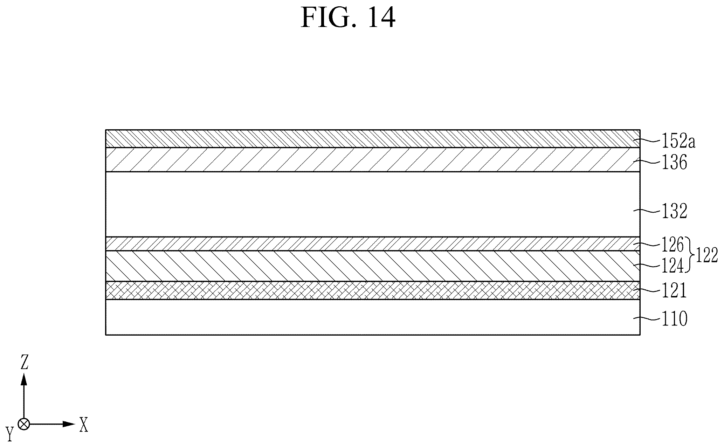

Hereinafter, a method of manufacturing semiconductor devices according to the present disclosure will be described with reference to FIG. 14 to FIG. 21. FIG. 14 to FIG. 21 are process cross-sectional views illustrating to a process sequence of manufacturing a semiconductor device. FIG. 14 to FIG. 21 show the method of manufacturing a semiconductor device according to the example of FIG. 1, but it will be understood that the same or similar operations can be applied to manufacture other semiconductor devices described herein.

First, as shown in FIG. 14, the seed layer 121, the buffer layer 122, the channel layer 132, the barrier layer 136, and the gate semiconductor material layer 152a may be sequentially formed on the substrate 110.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited thereto, and all generally-used substrates may be applied.

The seed layer 121 and the superlattice layer 124 may be sequentially formed by using an epitaxial growth method. The seed layer 121 and the superlattice layer 124 may be made of the same base semiconductor material. However, the material composition ratios of respective layers may be different in consideration of the role of respective layers, the performance required for the semiconductor device, or the like. The seed layer 121 and the superlattice layer 124 may include one or more material selected from Group III-V materials, for example, nitrides containing Al, Ga, In, B, or a combination thereof. The seed layer 121 and the superlattice layer 124 may be AlₓIn_{y}Ga_{1-x-y}N (0≤x≤1, 0≤y≤1, x+y≤1). For example, the seed layer 121 and the superlattice layer 124 may include AIN, GaN, InN, InGaN, AlGaN, AlInN, AllnGaN, or a combination thereof.

In some implementations, the superlattice layer 124 may be formed as multiple layers in which layers including different materials are alternately stacked. For example, the superlattice layer 124 may have a structure in which a layer formed of AlGaN and a layer formed of AIN are repeatedly stacked. That is, AlGaN/AlN/AlGaN/AlN/AlGaN/AlN may be sequentially stacked to form the superlattice layer 124.

The high-resistance layer 126 may be formed of a material having a conductivity, to electrically insulate the substrate 110 and the channel layer 132. The high-resistance layer may include one or more material selected from Group III-V materials, for example, nitrides containing Al, Ga, In, B, or a combination thereof. The high-resistance layer 126 may be AlₓIn_{y}Ga_{1-x-y}N (0≤x≤1, 0≤y≤1, x+y≤1). For example, the high-resistance layer 126 may include AIN, GaN, InN, InGaN, AlGaN, AlInN, AlInGaN, or a combination thereof. The high-resistance layer 126 may be formed in a single layer or multiple layers.

In some implementations, the channel layer 132 and the barrier layer 136 may be sequentially formed by using an epitaxial growth method. For example, the channel layer 132 may be formed on the high-resistance layer 126, and the barrier layer 136 may be formed on the channel layer 132.

The channel layer 132 and the barrier layer 136 may be made of the same base semiconductor material. However, the material composition ratios of respective layers may be different in consideration of the role of respective layers, the performance required for the semiconductor device, or the like. The channel layer 132 and the barrier layer 136 may include one or more material selected from Group III-V materials, for example, nitrides containing Al, Ga, In, B, or a combination thereof. The channel layer 132 and the barrier layer 136 may be AlₓIn_{y}Ga_{1-x-y}N (0≤x≤1, 0≤y≤1, x+y≤1). For example, the channel layer 132 and the barrier layer 136 may include AIN, GaN, InN, InGaN, AlGaN, AlInN, AllnGaN, or a combination thereof. The barrier layer 136 may include a material having a different energy band gap from the channel layer 132. The barrier layer 136 may have a higher energy band gap than the channel layer 132.

As an example, the substrate 110 may include Si, and the seed layer 121 may include AIN, and the superlattice layer 124 may include AlGaN and AIN. The high-resistance layer 126 may include GaN, and the channel layer 132 may include GaN, and the barrier layer 136 may include AlGaN. The channel layer 132 and the barrier layer 136 may or may not be doped with impurities.

As shown in FIG. 15, the gate electrode material layer 155a may be formed on the gate semiconductor material layer 152a. The gate semiconductor material layer 152a may be located between the barrier layer 136 and the gate electrode material layer 155a.

The gate electrode material layer 155a may be formed by using a deposition process. For example, the gate electrode material layer 155a may be performed by using at least one of physical vapor deposition (PVD), thermal chemical vapor deposition (thermal CVD), low-pressure chemical vapor deposition (LP-CVD), plasma-enhanced chemical vapor deposition (PE-CVD), or atomic layer deposition (ALD) technologies, but is not limited thereto.

The gate electrode material layer 155a may include a conductive material. For example, the gate electrode material layer 155a may include a metal, a metal alloy, a conductive metal nitride, a metal silicide, a doped semiconductor material, a conductive metal oxide, or a conductive metal nitride oxide, or the like. For example, the gate electrode material layer 155a may include titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), or a combination thereof, but is not limited thereto. The gate electrode material layer 155a may be formed in a single layer or multiple layers.

As shown in FIG. 16, by patterning the gate electrode material layer 155a and the gate semiconductor material layer 152a by using a photo and etching process, the gate electrode 155 and the gate semiconductor layer 152 may be formed.

For example, a hard mask layer, a photoresist layer may be sequentially formed on the gate electrode material layer 155a. By patterning the photoresist layer by using a photo process, a photoresist pattern may be formed. By etching the hard mask layer by using the photoresist pattern as a mask, a hard mask pattern may be formed. Subsequently, by etching the gate semiconductor material layer 152a by using the hard mask pattern as a mask, at least a portion of the gate semiconductor material layer 152a may be removed. Accordingly, a remaining portion of the gate electrode material layer 155a may become the gate electrode 155. In addition, a remaining portion of the gate semiconductor material layer 152a may become the gate semiconductor layer 152. The gate semiconductor layer 152 may be located between the barrier layer 136 and the gate electrode 155. The gate electrode 155 may be in Schottky contact or ohmic contact with the gate semiconductor layer 152. At this time, the hard mask layer may be removed depending on the etch condition or the cleaning condition after etching when etching the gate electrode material layer. Alternatively, the hard mask pattern may not be removed, but remain on the gate semiconductor layer 152.

By patterning the gate semiconductor material layer 152a and the gate electrode material layer 155a by using the same mask, the gate semiconductor layer 152 and the gate electrode 155 may have the same pattern. For example, the gate semiconductor layer 152 and the gate electrode 155 may have the same planar shape, e.g., in a plan view. In a cross-sectional view, the gate semiconductor layer 152 and the gate electrode 155 may have the same width. The gate semiconductor layer 152 may completely overlap with the gate electrode 155 in the third direction (Z direction), and the upper surface of the gate semiconductor layer 152 may be entirely covered by the gate electrode 155, but is not limited thereto. For example, the gate semiconductor layer 152 and the gate electrode 155 may partially overlap with each other in the third direction (Z direction).

At this time, dangling bonds DB may be present on the upper surface 136_U of the barrier layer 136. The dangling bond DB may mean a state in which some bonds of some atoms within the crystal structure of the barrier layer 136 with surrounding atoms are broken due to coordinative unsaturation. By the dangling bond DB existing on the upper surface 136_U of the barrier layer 136, the 2-dimensional electron gas 134 or the like may be trapped, or external impurities may be bonded, thereby deteriorating the device characteristics. Further, a point defect including a vacancy or the like may exist in the crystal structure of the barrier layer 136.

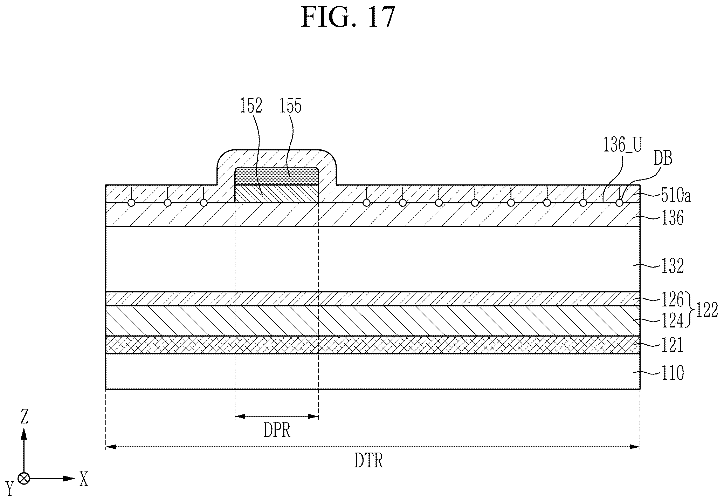

As shown in FIG. 17, the first protective layer 510 may be formed on the barrier layer 136 and the gate electrode 155. The first protective layer 510 may be formed by using a deposition process. In some implementations, the thickness of the first protective layer 510 along the third direction (Z direction) may be 200 nm or less. For example, the thickness of the first protective layer 510 along the third direction (Z direction) may be 100nm or less. The first protective layer 510 may include an oxide such as silicon oxide (SiO₂) or aluminum oxide (Al₂O₃), but is not limited thereto. As another example, the first protective layer 510 may include a nitride such as silicon nitride (SiN) or an oxynitride such as silicon oxynitride (SiON), into which deuterium (D) is implanted. Meanwhile, a point defect including a vacancy or the like may exist in the crystal structure of the first protective layer 510.

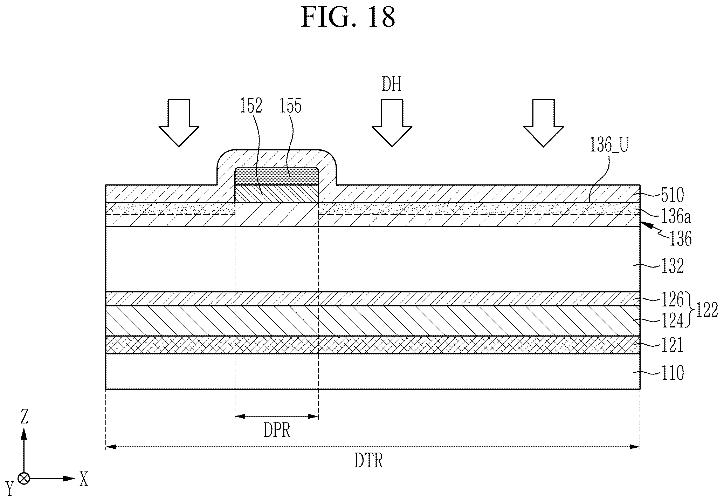

As shown in FIG. 18, the high-pressure deuterium (HPD) annealing process may be performed on the first protective layer 510.

The high-pressure deuterium (HPD) annealing process may be performed under a high temperature of about 150 °C to 600 °C, a deuterium atmosphere of 10% to 100%, and an air pressure of 1atm to 40atm. For example, the high-pressure deuterium (HPD) annealing process may be performed under a high temperature of about 400 °C to 550 °C. Accordingly, deuterium (D) may be implanted into the defect such as vacancies existing in the crystal structure of the first protective layer 510, and deuterium (D) may be bonded with surrounding elements. Accordingly, the first protective layer 510 may include deuterium (D). In some implementations, as the high-pressure deuterium (HPD) annealing is proceeded from the upper surface 510_U of the first protective layer 510, the content (at%) of deuterium (D) of the first protective layer 510 may increase away from the upper surface 136_U of the barrier layer 136, but is not limited thereto. For example, the content (at%) of deuterium (D) of the first protective layer 510 may have a section where the content is constant away from the upper surface 136_U of barrier layer 136.

Meanwhile, in some implementations, based on the thickness of the first protective layer 510 (e.g., because the thickness of the first protective layer 510 along the third direction (Z direction) is 200 nm (or 100 nm) or less), deuterium (D) may be implanted into the barrier layer 136. The thickness of the first protective layer 510 along the third direction (Z direction) being 200 nm (or 100 nm) or less, may permit deuterium (D) to be implanted into the barrier layer 136. Accordingly, the implant region 136a containing deuterium (D) may be formed in the barrier layer 136, and the dangling bond DB (see FIG. 16) located in the upper portion of the barrier layer 136 may be removed.

The implant region 136a may be located at the upper portion of the barrier layer 136. The implant region 136a may constitute or form at least a portion of an upper surface of the barrier layer 136. The implant region 136a may overlap with the channel layer 132 in the third direction (Z direction). The implant region 136a may be spaced apart from the upper surface 132_U of the channel layer 132 in the third direction (Z direction), but is not limited thereto. As another example, the implant region 136a may be in contact with the upper surface 132_U of the channel layer 132. In addition, the implant region 136a may not overlap with the gate electrode 155 and the gate semiconductor layer 152 in the third direction (Z direction) to be described later.

The implant region 136a may include deuterium (D). For example, the implant region 136a may be formed of AlGaN containing deuterium (D). In some implementations, as the high-pressure deuterium (HPD) annealing proceeds from the upper surface of the first protective layer 510, the content (at%) of deuterium (D) of the implant region 136a may increase away from an upper surface of the channel layer 132, but the content is not limited thereto.

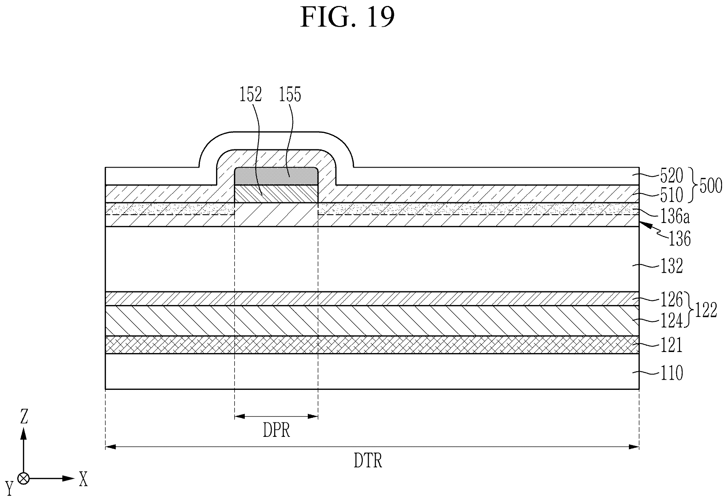

As shown in FIG. 19, the second protective layer 520 may be formed on the first protective layer 510. Since the second protective layer 520 is performed after performing the above-described the high-pressure deuterium (HPD) annealing process, the second protective layer 520 may not contain deuterium (D).

As shown in FIG. 20, by patterning the protective layer 500 by using a photo and etching process, a first trench 141 and a second trench 143 may be formed. At this time, not only the protective layer 500 but also the barrier layer 136 and the channel layer 132 may be patterned together.

For example, a photoresist pattern may be formed on the second protective layer 520, and by using this as a mask, the second protective layer 520, the first protective layer 510, the barrier layer 136, and the channel layer 132 may be sequentially etched. At this time, by the first trench 141 and the second trench 143, the second protective layer 520, the first protective layer 510, and the barrier layer 136 may be penetrated, and the upper surface of the channel layer 132 may be recessed. The channel layer 132 may not be penetrated by the first trench 141 or the second trench 143. For example, the depth by which the upper surface of the channel layer 132 is recessed may be smaller than an entire thickness of the channel layer 132. The depth by which the upper surface of the channel layer 132 is recessed may be much smaller than the entire thickness of the channel layer 132. In addition, the depth by which the upper surface of the channel layer 132 is recessed may be greater than a thickness of the barrier layer 136. However, it is not limited thereto, and the depth by which the upper surface of the channel layer 132 is recessed may be changed in various ways.

In the first trench 141 and the second trench 143, side surfaces of the second protective layer 520, the first protective layer 510, and the barrier layer 136 may be externally exposed, and the upper surface and a side surface of the channel layer 132 may be exposed. The channel layer 132 may form a bottom surface and a side wall of the first trench 141 and the second trench 143, and the barrier layer 136 may form side walls of the first trench 141 and the second trench 143.

The first trench 141 and the second trench 143 may be spaced apart from each other. The first trench 141 and the second trench 143 may be located on opposite sides of the gate electrode 155. The first trench 141 may be located on the first side of the gate electrode 155 to be spaced apart from the gate electrode 155. The second trench 143 may be located on the second side of the gate electrode 155 to be spaced apart from the gate electrode 155. The distance by which the first trench 141 is spaced apart from the gate electrode 155 may be smaller than the distance by which the second trench 143 is spaced apart from the gate electrode 155. The first trench 141 and the second trench 143 are illustrated to have similar shape such as width and depth, but is not limited thereto. The shapes of the first trench 141 and the second trench 143 may be variously changed.

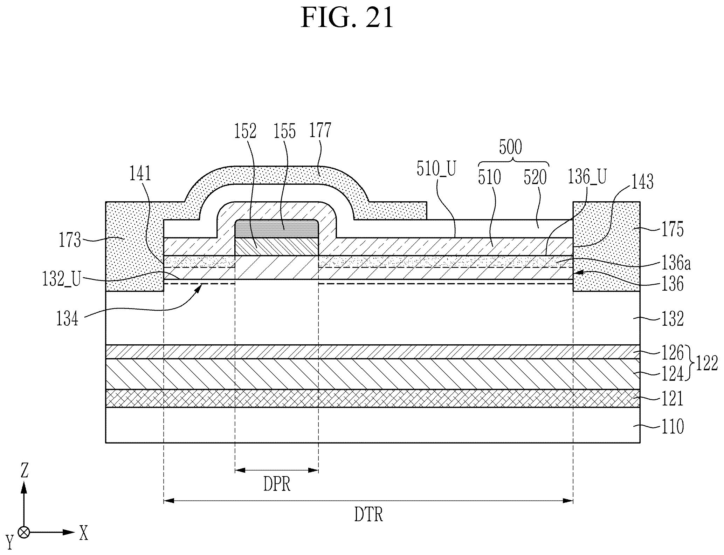

As shown in FIG. 21, a conductive material may be deposited in the first trench 141 and the second trench 143, and by patterning it, the source electrode 173 and the drain electrode 175 may be formed.

The source electrode 173 and the drain electrode 175 may include a conductive material. For example, the source electrode 173 and the drain electrode 175 may include a metal, a metal alloy, a conductive metal nitride, a metal silicide, a doped semiconductor material, a conductive metal oxide, or a conductive metal nitride oxide, or the like. The source electrode 173 and the drain electrode 175 may be formed in a single layer or multiple layers. For example, by stacking a plurality of conductive layers including different materials and then patterning them, the source electrode 173 and the drain electrode 175 may be formed. At this time, the plurality of conductive layers may be simultaneously or sequentially etched by using one mask pattern. For example, by sequentially stacking Ti, Al, Ti, and TiN and then patterning them, the source electrode 173 and the drain electrode 175 may be formed. At this time, the thicknesses of four conductive layers constituting the source electrode 173 and the drain electrode 175 may be similar, and may be different. For example, a layer formed of Al may be relatively thick compared to other layers.

The source electrode 173 may be formed to fill an interior of the first trench 141. In addition, the source electrode 173 may be formed to cover at least a portion of the upper surface of the channel layer 132. Accordingly, at least a portion of source electrode 173 may overlap with the channel layer 132, the barrier layer 136, and the drift region (DTR), in the third direction (Z direction). Within the first trench 141, the source electrode 173 may be in contact with the channel layer 132 and the barrier layer 136. The source electrode 173 may be in contact with the side surfaces of the channel layer 132 and the barrier layer 136. The source electrode 173 may cover the side surfaces of the channel layer 132 and the barrier layer 136. The source electrode 173 may be electrically connected to the channel layer 132 through the first trench 141. The upper surface of the source electrode 173 may protrude more than the upper surface of the second protective layer 520.

The drain electrode 175 may be formed to fill an interior of the second trench 143. In addition, the drain electrode 175 may be formed to cover at least a portion of the upper surface of the channel layer 132. Accordingly, at least a portion of the drain electrode 175 may overlap with the channel layer 132, the barrier layer 136, and the drift region (DTR), in the third direction (Z direction). Within the second trench 143, the drain electrode 175 may be in contact with the channel layer 132 and the barrier layer 136. The drain electrode 175 may be in contact with the side surfaces of the channel layer 132 and the barrier layer 136. The drain electrode 175 may cover the side surfaces of the channel layer 132 and the barrier layer 136. The drain electrode 175 may be electrically connected to the channel layer 132 through the second trench 143. The upper surface of the drain electrode 175 may protrude more than the upper surface of the second protective layer 520.

The source electrode 173 and the drain electrode 175 may be in ohmic contact with the channel layer 132. A region in contact with the source electrode 173 and the drain electrode 175 in the channel layer 132 may be doped at a relatively high concentration compared to other regions. For example, the channel layer 132 may be doped by an ion implant process, an annealing process, or the like. However, the doping is not limited thereto, and doping process of the channel layer 132 may be formed by various other processes. The doping process of the channel layer 132 may be performed before forming the source electrode 173 and the drain electrode 175. In some implementations, the channel layer 132 may not be doped.

Inside the channel layer 132, the 2-dimensional electron gas 134 may be formed in a portion adjacent to the barrier layer 136. The 2-dimensional electron gas 134 may located at an interface between the channel layer 132 and the barrier layer 136. The 2-dimensional electron gas 134 may be located in the drift region DTR between the source electrode 173 and the drain electrode 175. The depletion region DPR may be formed in the channel layer 132 by the gate semiconductor layer 152 having a different energy band gap from the barrier layer 136. Therefore, the semiconductor device may have normally-off characteristics. For example, the semiconductor device may be a normally-off high electron mobility transistor (HEMT). In the gate-off state, the 2-dimensional electron gas 134 may be located within the drift region DTR excluding the depletion region DPR of the channel layer 132. In the gate-on state, the flow of the 2-dimensional electron gas 134 continues within the depletion region DPR, and the two-dimensional electron gas 134 may be entirely located within the drift region DTR.

In the step of forming the source electrode 173 and the drain electrode 175, the field dispersion layer 177 may be formed together with the electrodes 173, 175. The field dispersion layer 177 may be located between the source electrode 173 and the drain electrode 175. The field dispersion layer 177 may overlap with the gate electrode 155. The field dispersion layer 177 may be electrically connected to the source electrode 173. The field dispersion layer 177 may be integrally formed with the source electrode 173. The field dispersion layer 177 may include the same material as the source electrode 173, and may be located on the same layer as the source electrode 173.

Accordingly, the first protective layer 510 may be located on the barrier layer 136 between the source electrode 173 and the drain electrode 175. The first protective layer 510 may overlap with the drift region DTR of the channel layer 132 along the third direction (Z direction).

In addition, the first protective layer 510 and the second protective layer 520 may be located between the barrier layer 136 and the field dispersion layer 177. At least a portion of the first protective layer 510 and the second protective layer 520 may overlap with the field dispersion layer 177 along the third direction (Z direction). Therefore, a portion of the first protective layer 510 and a portion of the second protective layer 520 that overlap with the field dispersion layer 177 in the third direction (Z direction) may cover the gate semiconductor layer 152 and the gate electrode 155. Accordingly, the barrier layer 136, the gate semiconductor layer 152, and the gate electrode 155 may be protected by the protective layer 500.

In the foregoing description, it was described that a conductive material is deposited on the second protective layer 520, and by patterning this, the source electrode 173 and the drain electrode 175 may be formed, but fabrication of the electrodes 173, 175 is not limited thereto.

Hereinafter, a method of manufacturing a semiconductor device according to some implementations of the present disclosure will be described with reference to FIG. 22 to FIG. 25. FIG. 22 to FIG. 25 are process cross-sectional views showing a process sequence of manufacturing a semiconductor device. FIG. 22 to FIG. 25 show the method of manufacturing a semiconductor device according to the example of FIG. 8, but it will be understood that the same or similar operations can be applied to manufacture other semiconductor devices described herein.

The process shown in FIG. 22 to FIG. 25 has substantially the same operations as the process shown in FIG. 14 to FIG. 19, and therefore, a description thereof will be omitted while differences will be mainly described. In addition, same reference numerals will be used for the same components as the previous example.

As shown in FIG. 22, the seed layer 121, the buffer layer 122, the channel layer 132, the barrier layer 136, the gate semiconductor layer 152, and the gate electrode 155 may be sequentially formed on the substrate 110. Descriptions of the substrate 110, the seed layer 121, the buffer layer 122, the channel layer 132, the barrier layer 136, the gate semiconductor layer 152, and the gate electrode 155 are substantially the same as descriptions of the seed layer 121, the buffer layer 122, the channel layer 132, the barrier layer 136, the gate semiconductor layer 152, and the gate electrode 155 of the process of FIG. 14 to FIG. 21, and will be omitted.

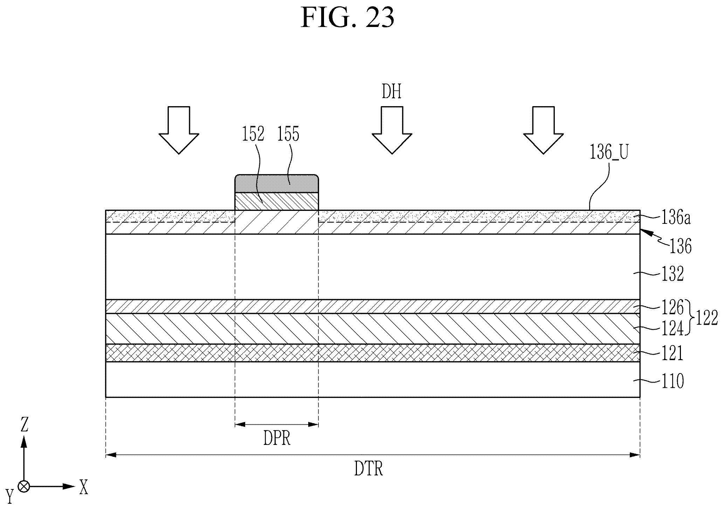

As shown in FIG. 23, the high-pressure deuterium (HPD) annealing process may be performed on the upper surface 136_U of the barrier layer 136.

The high-pressure deuterium (HPD) annealing process may be performed under a high temperature of about 150 °C to 600 °C, a deuterium atmosphere of 10% to 100%, and an air pressure of 1atm to 40atm. For example, the high-pressure deuterium (HPD) annealing process may be performed under a high temperature of about 400 °C to 550 °C. Accordingly, deuterium (D) may be implanted into the defect such as vacancies existing in the crystal structure of the barrier layer 136, and deuterium (D) may be bonded with surrounding elements. In addition, the dangling bond DB located in the upper portion of the barrier layer 136 may be removed, and the implant region 136a containing deuterium (D) may be formed in the barrier layer 136. In some implementations, as the high-pressure deuterium (HPD) annealing is proceeded from the upper surface 136_U of the barrier layer 136, the content (at%) of deuterium (D) of the implant region 136a may increase away from the upper surface of the channel layer 132, but is not limited thereto.

In some implementations, since the gate semiconductor layer 152 and the gate electrode 155 are located on the barrier layer 136, deuterium (D) may not be implanted into a portion of the barrier layer 136 that overlaps with the gate semiconductor layer 152 and the gate electrode 155 in the third direction (Z direction). For example, the implant region 136a may not overlap with the gate semiconductor layer 152 and the gate electrode 155 along the third direction (Z direction).

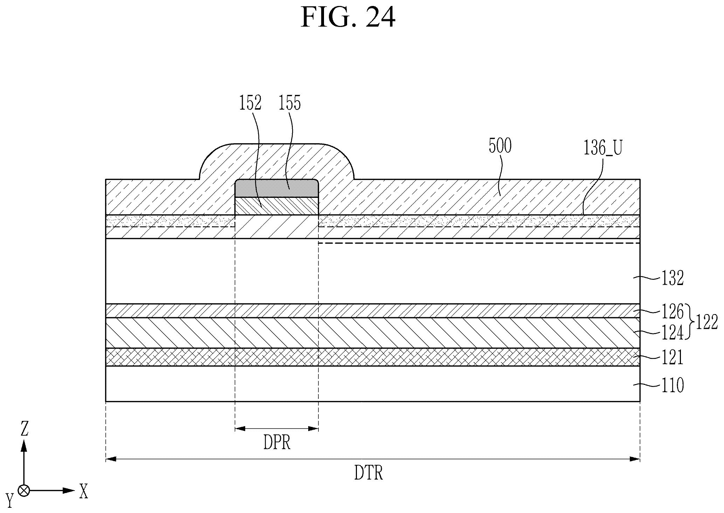

As shown in FIG. 24, the protective layer 500 may be formed on the barrier layer 136 and the gate electrode 155. The protective layer 500 may be formed by using a deposition process. In FIG. 24, it was illustrated that the protective layer 500 is formed as a single layer, but it is not limited thereto, and it may be formed as multiple layers.

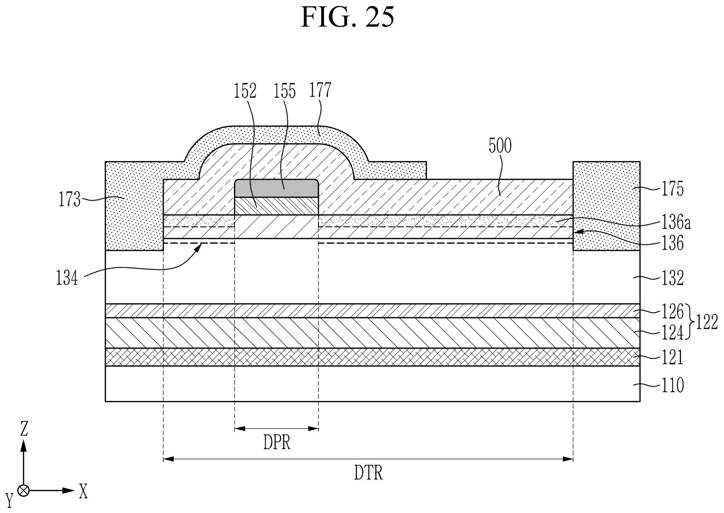

Referring to FIG. 25, first, by patterning the protective layer 500 by using a photo and etching process, the first trench 141 and the second trench 143 may be formed. At this time, not only the protective layer 500 but also the barrier layer 136 and the channel layer 132 may be patterned together. Finally, a conductive material may be deposited in the first trench 141 and the second trench 143, and by patterning it, the source electrode 173 and the drain electrode 175 may be formed, thereby forming the semiconductor device.

While this disclosure contains many specific implementation details, these should not be construed as limitations on the scope of what may be claimed. Certain features (e.g., floating pattern presence/configurations) that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination. For example, features of the examples of FIGS. 1 and 6 to 13 can be variously combined without departing from the scope of this disclosure.

While this disclosure has been described in connection with various examples, it is to be understood that the disclosure is not limited to those examples, but, on the contrary, is intended to cover various modifications and equivalent arrangements included within the scope of the disclosure.

Embodiments are set out in the following clauses.
Clause 1. A semiconductor device, comprising:
   a channel layer comprising GaN;
   a barrier layer on the channel layer, wherein the barrier layer comprises AlGaN and comprises an implant region that includes deuterium;
   a gate electrode on the barrier layer and comprising a metal material;
   a gate semiconductor layer between the barrier layer and the gate electrode, wherein the gate semiconductor layer comprises GaN doped with p-type impurities;
   a protective layer on the barrier layer and covering the gate electrode; and
   a source electrode and a drain electrode on opposite lateral sides of the gate electrode, wherein the source electrode and the drain electrode are electrically connected to the channel layer,
   wherein the protective layer comprises:
      a first protective layer on the implant region and comprising deuterium, and
      a second protective layer on the first protective layer.
Clause 2. The semiconductor device of clause 1, wherein:
   the implant region is in contact with the first protective layer; and
   the implant region is non-overlapping with the gate electrode along a vertical direction.
Clause 3. The semiconductor device of clause 1 or clause 2, wherein a concentration of deuterium in the implant region is smaller than or equal to a concentration of deuterium in the first protective layer.
Clause 4. The semiconductor device of any of any of clauses 1 to 3, wherein a concentration of deuterium in the implant region increases in a vertical direction away from an upper surface of the channel layer.
Clause 5. A semiconductor device, comprising:
   a channel layer;
   a barrier layer on the channel layer, wherein the barrier layer comprises a material having a different energy band gap from a material of the channel layer, and wherein the barrier layer comprises an implant region including deuterium;
   a gate electrode on the barrier layer;
   a gate semiconductor layer between the barrier layer and the gate electrode;
   a protective layer on the implant region and covering the gate electrode; and
   a source electrode and a drain electrode on opposite lateral sides of the gate electrode, wherein the source electrode and the drain electrode are electrically connected to the channel layer,
   wherein the implant region is between a first position that overlaps the gate electrode along a vertical direction and a second position that overlaps the source electrode along the vertical direction, and is between a third position that overlaps the gate electrode along the vertical direction and a fourth position that overlaps the drain electrode along the vertical direction, and
   wherein the protective layer comprises:
      a first protective layer on the barrier layer and comprising silicon oxide including deuterium, and
      a second protective layer on the first protective layer and comprising silicon oxide, silicon nitride, or silicon nitride oxide, wherein the silicon oxide, silicon nitride, or silicon nitride oxide of the second protective layer is substantially free of deuterium.
Clause 6. A semiconductor device, comprising:
   a channel layer;
   a barrier layer on the channel layer, wherein the barrier layer comprises a material having a different energy band gap from a material of the channel layer;
   a gate electrode on the barrier layer;
   a gate semiconductor layer between the barrier layer and the gate electrode;
   a protective layer on the barrier layer and covering the gate electrode;
   a source electrode and a drain electrode on opposite lateral sides of the gate electrode, wherein the source electrode and the drain electrode are electrically connected to the channel layer;
   a field dispersion layer on the protective layer and electrically connected to the source electrode; and
   an upper protective layer covering the field dispersion layer and the protective layer,
   wherein the protective layer comprises a second insulating material that is substantially free of deuterium, and
   wherein the upper protective layer comprises a first insulating material that includes deuterium.

## Claims

1. A semiconductor device, comprising:
a channel layer (132);
a barrier layer (136) on the channel layer (132), wherein the barrier layer (136) comprises a material having a different energy band gap from a material of the channel layer (132);
a gate electrode (155) on the barrier layer (136);
a gate semiconductor layer (152) between the barrier layer (136) and the gate electrode (155);
a protective layer (500) on the barrier layer (136) and covering the gate electrode (155); and
a source electrode (173) and a drain electrode (175) on opposite lateral sides of the gate electrode (155), wherein the source electrode (173) and the drain electrode (175) are electrically connected to the channel layer (132),
wherein the protective layer (500) comprises:
a first protective layer (510) on the barrier layer (136) and comprising a first insulating material including deuterium, and
a second protective layer (520) located on the first protective layer (510) and comprising a second insulating material that is substantially free of deuterium.

2. The semiconductor device of claim 1, wherein a concentration of deuterium in the first protective layer (510) increases in a vertical direction (Z) away from an upper surface (136_U) of the barrier layer (136).

3. The semiconductor device of claim 2, wherein the concentration of deuterium in the first protective layer (510) has a maximum value at an upper surface (510_U) of the first protective layer (510).

4. The semiconductor device of any preceding claim, wherein:
the first insulating material comprises silicon oxide; and
the second insulating material comprises silicon oxide, silicon nitride, or silicon nitride oxide.

5. The semiconductor device of any preceding claim, wherein a thickness of the first protective layer (510) is smaller than a thickness of the second protective layer (520).

6. The semiconductor device of claim 5, wherein the thickness of the first protective layer (510) is 200 nm or less.

7. The semiconductor device of any preceding claim, wherein the first protective layer (510) covers a side surface and an upper surface of the gate electrode (155).

8. The semiconductor device of claim 7, further comprising a field dispersion layer (177) integrally formed with the source electrode (173) and located on the second protective layer (520),
wherein the field dispersion layer (177) overlaps the gate electrode (155) along a vertical direction (Z).

9. The semiconductor device of any preceding claim, wherein:
the barrier layer (136) comprises an implant region (136a) including deuterium; and
the implant region (136a) is located in an upper portion of the barrier layer (136).

10. The semiconductor device of claim 9, wherein the implant region (136a) is overlapping with the first protective layer (510) along a vertical direction (Z) and nonoverlapping with the gate electrode (155) along the vertical direction (Z).

11. The semiconductor device of claim 9 or claim 10, wherein a concentration of deuterium in the implant region (136a) increases in a vertical direction (Z) away from an upper surface (132_U) of the channel layer (132).

12. The semiconductor device of claim 11, wherein a concentration of deuterium in the first protective layer (510) has a maximum value at an upper surface (510_U) of the first protective layer (510).

13. The semiconductor device of any of claims 9-12, wherein a concentration of deuterium in the first protective layer (510) is greater than or equal to a concentration of deuterium in the implant region (136a).

14. The semiconductor device of any of claims 9-13, wherein:
an upper surface of the implant region (136a) is in contact with the first protective layer (510); and
a lower surface of the implant region (136a) is in contact with the channel layer (132).

15. The semiconductor device of any of claims 9-14, wherein a side surface of the implant region (136a) is in contact with the source electrode (173) and the drain electrode (175).
